# EUROPEAN PATENT APPLICATION

(11) **EP 4 682 958 A1**
(43) Date of publication of application: **21.01.2026**
(21) Application number: 24774861.9
(22) Date of filing: 15.03.2024
(51) Int. Cl.: H01L 27/146, H04N 25/70, H04N 25/79

(54) **SEMICONDUCTOR DEVICE**

(30) Priority: 17.03.2023 JP 2023042942
(71) Applicant: Sony Semiconductor Solutions Corporation, Atsugi-shi, Kanagawa 243-0014 (JP)
(72) Inventor: YOKOYAMA, Takashi, Atsugi-shi, Kanagawa 243-0014 (JP); NITTA, Yosuke, Atsugi-shi, Kanagawa 243-0014 (JP); SHIMIZU, Kan, Atsugi-shi, Kanagawa 243-0014 (JP)
(74) Representative: MFG Patentanwälte Meyer-Wildhagen Meggle-Freund Gerhard PartG mbB
(86) International application number: PCT/JP2024/010258
(87) International publication number: WO 2024/195725

(57) **Abstract**

A semiconductor device according to one embodiment of the present disclosure includes a first substrate, a second substrate, and a third substrate. The first substrate has a first surface and a second surface that are opposed to each other. The first substrate includes a plurality of semiconductor elements formed on a side of the first surface. The second substrate is mounted on the second surface of the first substrate. The second substrate includes a plurality of semiconductor layers being stacked. The plurality of semiconductor layers each include one or a plurality of circuits. The third substrate is mounted side by side to the second substrate on the second surface of the first substrate. The third substrate includes one or a plurality of semiconductor layers being stacked. The one or the plurality of semiconductor layers each include one or a plurality of circuits.

## Description

### Technical Field

The present disclosure relates to a semiconductor device having a three-dimensional structure.

### Background Art

For example, Patent Literature 1 discloses a backside illumination type solid-state imaging device in which, under a solid-state imaging element, a singulated memory circuit and a singulated logic circuit are laid out in a horizontal direction and are embedded by an oxide film.

### Citation List

### Patent Literature

Patent Literature 1: International Publication No. WO2019/087764

### Summary of the Invention

Incidentally, for the imaging device, it is desired to achieve both of high functionality and reduction in cost.

It is thus desirable to provide a semiconductor device that achieves both of high functionality and reduction in cost.

A semiconductor device according to one embodiment of the present disclosure includes a first substrate, a second substrate, and a third substrate. The first substrate has a first surface and a second surface that are opposed to each other. The first substrate includes a plurality of semiconductor elements formed on a side of the first surface. The second substrate is mounted on the second surface of the first substrate. The second substrate includes a plurality of semiconductor layers being stacked. The plurality of semiconductor layers each include one or a plurality of circuits. The third substrate is mounted side by side to the second substrate on the second surface of the first substrate. The third substrate includes one or a plurality of semiconductor layers being stacked. The one or the plurality of semiconductor layers each include one or a plurality of circuits.

In the semiconductor device according to one embodiment of the present disclosure, the second substrate and the third substrate are mounted on the second surface on a side opposite to the first surface, of the first substrate including the plurality of semiconductor elements formed on the side of the first surface. The second substrate includes the plurality of semiconductor layers being stacked and each including the one or the plurality of circuits. The third substrate includes the one or the plurality of semiconductor layers being stacked and each including the one or the plurality of circuits. This allows a desired circuit chip to be mounted at a desired position.

### Brief Description of the Drawings

[FIG. 1] FIG. 1 is a schematic cross-sectional view illustrating an example of a configuration of an imaging device according to an embodiment of the present disclosure.
[FIG. 2] FIG. 2 is a schematic cross-sectional view illustrating another example of the configuration of the imaging device according to the embodiment of the present disclosure.
[FIG. 3] FIG. 3 is an explanatory flowchart illustrating a manufacturing process of the imaging device illustrated in FIG. 1 and FIG. 2.
[FIG. 4] FIG. 4 is an exploded perspective view illustrating an example of a schematic configuration of the imaging device illustrated in FIG. 1 and FIG. 3.
[FIG. 5] FIG. 5 is an exploded perspective view illustrating a mode of coupling in a pixel array section of the imaging device illustrated in FIG. 2.
[FIG. 6] FIG. 6 is an explanatory view illustrating coupling of each of circuits provided in sensor pixels, a readout circuit, and a plurality of semiconductor layers configuring a first CoW layer illustrated in FIG. 5.
[FIG. 7] FIG. 7 is an exploded perspective diagram illustrating a mode of coupling in a peripheral section of the imaging device illustrated in FIG. 2.
[FIG. 8] FIG. 8 is an exploded perspective view illustrating a mode of coupling in a pixel array section of an imaging device according to Modification Example 1 of the present disclosure.
[FIG. 9] FIG. 9 is an exploded perspective view illustrating a mode of coupling in a peripheral section of the imaging device according to Modification Example 1 of the present disclosure.
[FIG. 10] FIG. 10 is a schematic cross-sectional view illustrating an example of a configuration of an imaging device according to Modification Example 2 of the present disclosure.
[FIG. 11] FIG. 11 is a schematic cross-sectional view illustrating another example of the configuration of the imaging device according to Modification Example 2 of the present disclosure.
[FIG. 12] FIG. 12 is a schematic cross-sectional view illustrating another example of the configuration of the imaging device according to Modification Example 2 of the present disclosure.
[FIG. 13] FIG. 13 is a schematic cross-sectional view illustrating an example of a configuration of an imaging device according to Modification Example 3 of the present disclosure.
[FIG. 14] FIG. 14 is a block diagram illustrating circuits to be mounted on a first CoW layer and a second CoW layer of the imaging device illustrated in FIG. 13.
[FIG. 15] FIG. 15 is a diagram illustrating an example of a schematic configuration of an imaging system including the imaging device according to any one of the above-mentioned embodiment and Modification Examples 1 to 4.
[FIG. 16] FIG. 16 is a diagram illustrating an example of an imaging procedure in the imaging system of FIG. 15.
[FIG. 17] FIG. 17 is a block diagram depicting an example of schematic configuration of a vehicle control system.
[FIG. 18] FIG. 18 is a diagram of assistance in explaining an example of installation positions of an outside-vehicle information detecting section and an imaging section.
[FIG. 19] FIG. 19 is a view depicting an example of a schematic configuration of an endoscopic surgery system.
[FIG. 20] FIG. 20 is a block diagram depicting an example of a functional configuration of a camera head and a camera control unit (CCU).
[FIG. 21] FIG. 21 is a schematic cross-sectional view illustrating an example of a configuration of an imaging device according to Modification Example 4 of the present disclosure.
[FIG. 22A] FIG. 22A is an explanatory schematic cross-sectional view illustrating an example of a manufacturing process of the imaging device illustrated in FIG. 21.
[FIG. 22B] FIG. 22B is a schematic cross-sectional view illustrating a process subsequent to FIG. 22A.
[FIG. 22C] FIG. 22C is a schematic cross-sectional view illustrating a process subsequent to FIG. 22B.
[FIG. 22D] FIG. 22D is a schematic cross-sectional view illustrating a process subsequent to FIG. 22C.
[FIG. 22E] FIG. 22E is a schematic cross-sectional view illustrating a process subsequent to FIG. 22D.
[FIG. 22F] FIG. 22F is a schematic cross-sectional view illustrating a process subsequent to FIG. 22E.
[FIG. 22G] FIG. 22G is a schematic cross-sectional view illustrating a process subsequent to FIG. 22F.
[FIG. 22H] FIG. 22H is a schematic cross-sectional view illustrating a process subsequent to FIG. 22G.
[FIG. 23] FIG. 23 is a schematic cross-sectional view illustrating an example of a configuration of an imaging device according to Modification Example 5 of the present disclosure.
[FIG. 24] FIG. 24 is a schematic cross-sectional view illustrating an example of a configuration of an imaging device according to Modification Example 6 of the present disclosure.
[FIG. 25] FIG. 25 is a schematic cross-sectional view illustrating another example of the configuration of the imaging device according to Modification Example 6 of the present disclosure.
[FIG. 26] FIG. 26 is a schematic cross-sectional view illustrating another example of the configuration of the imaging device according to Modification Example 6 of the present disclosure.
[FIG. 27] FIG. 27 is a schematic cross-sectional view illustrating an example of a configuration of an imaging device according to Modification Example 7 of the present disclosure.
[FIG. 28] FIG. 28 is a schematic cross-sectional view illustrating another example of the configuration of the imaging device according to Modification Example 7 of the present disclosure.
[FIG. 29] FIG. 29 is a schematic cross-sectional view illustrating another example of the configuration of the imaging device according to Modification Example 7 of the present disclosure.
[FIG. 30] FIG. 30 is a schematic cross-sectional view illustrating another example of the configuration of the imaging device according to Modification Example 7 of the present disclosure.

### Modes for Carrying Out the Invention

Hereinafter, an embodiment of the present disclosure is described in detail with reference to the drawings. The following description is a specific example of the present disclosure, and the present disclosure is not limited to the following embodiment. Moreover, the present disclosure does not limit the disposition, dimensions, dimension ratios, and the like of respective components illustrated in the drawings thereto. It is to be noted that description is given in the following order.
1. Embodiment (an example of an imaging device including, on a front surface side of a sensor substrate, a plurality of CoW layers mounted in a planar direction, the plurality of CoW layers each including one or a plurality of layers)
2. Modification Examples
   2-1. Modification Example 1 (another example of coupling in a pixel array section of the imaging device)
   2-2. Modification Example 2 (another example of the configuration of the imaging device)
   2-3. Modification Example 3 (another example of the configuration of the imaging device)
   2-4. Modification Example 4 (another example of the configuration of the imaging device)
   2-5. Modification Example 5 (another example of the configuration of the imaging device)
   2-6. Modification Example 6 (another example of the configuration of the imaging device)
   2-7. Modification Example 7 (another example of the configuration of the imaging device)
3. Application Example
4. Usage Examples

### <1. Embodiment>

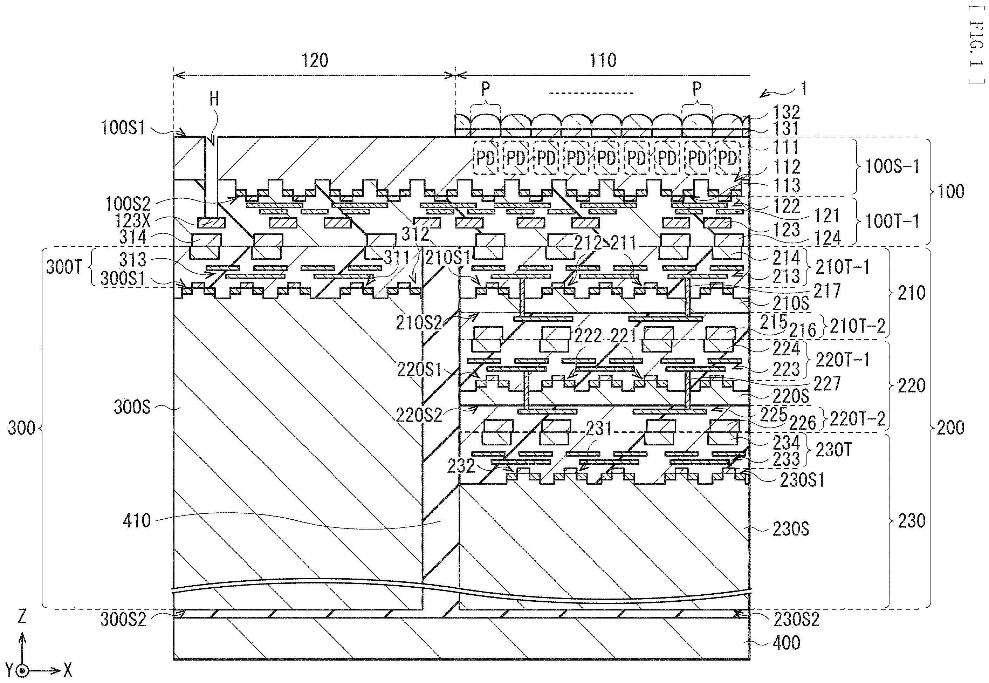

FIG. 1 is a diagram schematically illustrating an example of a cross-sectional configuration of an imaging device according to an embodiment of the present disclosure (an imaging device 1). The imaging device 1 has a three-dimensional structure in which, under a sensor substrate 100, a plurality of layers each having a chip on wafer (CoW) structure (hereinafter referred to as "CoW layers") is disposed side by side in a planar direction (an XY direction) of the sensor substrate 100. The CoW layers each include one or a plurality of semiconductor layers being stacked.

### [Configuration of Imaging Device]

The imaging device 1 is what is called a backside illumination type imaging device that receives light from a back surface side of the sensor substrate 100 (for example, a back surface (a surface 100S1) of a semiconductor layer 100S configuring the sensor substrate 100). The imaging device 1 includes a plurality of (in this case, two) CoW layers (a first CoW layer 200 and a second CoW layer 300) mounted side by side on a front surface (surface 100S2) side of the sensor substrate 100. The CoW layers each include one or a plurality of semiconductor layers being stacked. The sensor substrate 100 and the first CoW layer 200 are electrically coupled to each other by hybrid bonding, and the sensor substrate 100 and the second CoW layer 300 are electrically coupled to each other by hybrid bonding. The first CoW layer 200 and the second CoW layer 300 are electrically coupled to each other via the sensor substrate 100. An insulating layer 410 is embedded between the first CoW layer 200 and the second CoW layer 300. On surfaces of the first CoW layer 200 and the second CoW layer 300 on a side opposite to surfaces thereof facing the sensor substrate 100, a common support substrate 400 shared by the first CoW layer 200 and the second CoW layer 300 is provided.

The above-described sensor substrate 100 corresponds to a specific example of a "first substrate" in the embodiment of the present disclosure. The first CoW layer 200 corresponds to a specific example of a "second substrate" in the embodiment of the present disclosure. The second CoW layer 300 corresponds to a specific example of a "third substrate" in the embodiment of the present disclosure.

The sensor substrate 100 includes the semiconductor layer 100S having a pair of opposing surfaces (the front surface (the surface 100S2) and the back surface (the surface 100S2), and a wiring layer 100T provided on the surface 100S2 side of the semiconductor layer 100S.

The semiconductor layer 100S includes a pixel array section 110 including a plurality of sensor pixels P disposed in an array shape, and a peripheral section 120 provided around the pixel array section 110. The pixel array section 110 includes, as a light receiving element 111, for example, a photodiode PD that performs photoelectric conversion, and the photodiode PD is formed to be embedded in each of the plurality of sensor pixels P. Moreover, on the surface 100S2 of the semiconductor layer 100S, for example, floating diffusions FD (not shown) and a plurality of pixel transistors (for example, a plurality of p-MOS transistors 112 and a plurality of n-MOS transistors 113) are provided. One floating diffusion FD is provided for each of the sensor pixels P or for a plurality of sensor pixels P. The plurality of pixel transistors configures a readout circuit that outputs pixel signals on the basis of electric charge output from the sensor pixels P. The peripheral section 120 includes, in addition to the plurality of p-MOS transistors 112 and the plurality of n-MOS transistors 113, for example, an opening H provided to reach a pad electrode 123X for use in electrical coupling to the outside. The pad electrode 123X is exposed to the surface 100S1 side through the opening H passing between the surface 100S1 and the surface 100S2 of the semiconductor layer 100S.

The semiconductor layer 100S includes, for example, a silicon (Si) substrate. It is possible for the semiconductor layer 100S to use, other than the Si substrate, a semiconductor substrate including germanium (Ge), selenium (Se), carbon (C), gallium arsenide (GaAs), gallium phosphide (GaP), nickel antimonide (NiSb), indium antimonide (InSb), indium arsenide (InAs), indium phosphide (InP), gallium nitride (GaN), silicon carbide (SiC), or indium gallium arsenide (InGaAs).

In the wiring layer 100T, for example, wirings coupled to the floating diffusions FD, wirings including, for example, gates of the plurality of p-MOS transistors 112 and the plurality of n-MOS transistors 113 configuring the readout circuit, and wirings 122 and 123 including the pad electrode 123X and the like are formed within an interlayer insulating layer 121. At a front surface of the wiring layer 100T (specifically, on a front surface of the interlayer insulating layer 121), a plurality of pad portions 124 is exposed. The plurality of pad portions 124 is used to achieve, for example, bonding and electrically coupling to the first CoW layer 200 and the second CoW layer 300. The plurality of pad portions 124 is coupled to, although not shown, for example, the floating diffusions FD and the gates of the plurality of p-MOS transistors 112 and the plurality of n-MOS transistors 113 through vias.

On the surface 100S1 side of the semiconductor layer 100S, for example, a color filter 131 and a light receiving lens 132 are provided.

For example, the first CoW layer 200 is mounted at a position corresponding to the pixel array section 110 of the sensor substrate 100. The first CoW layer 200 has a chip structure including a plurality of semiconductor layers being stacked (in this case, a first layer 210, a second layer 220, and a third layer 230). The first layer 210, the second layer 220, and the third layer 230 each include one or a plurality of circuits different from each other in technology node.

Here, the phrase "different from each other in technology node" means that, for example, at least one of a minimum power supply voltage (Vdd), a film thickness of a gate insulating film of a transistor configuring each of the circuits, a gate length (lg) and a minimum gate pitch (Pg) of the transistor configuring each of the circuits, or a wiring width and a minimum wiring pitch (Pm) of the wiring provided in each of the circuits is different.

Specifically, in the first layer 210, for example, a 22-nm-node analog circuit is formed. In the second layer 220, for example, a 5-nm-node logic circuit is formed. In the third layer 230, for example, a memory such as a Dynamic Random Access Memory (DRAM) is mounted. The first layer 210, the second layer 220, and the third layer 230 are electrically coupled to each other by hybrid bonding.

The first layer 210 includes a semiconductor layer 210S having a surface 210S2 and a surface 210S2 forming a pair and being opposed to each other, a wiring layer 210T-1 provided on a surface 210S1 side of the semiconductor layer 210S, and a wiring layer 210T-2 provided on the surface 210S2 side of the semiconductor layer 210S. On the surface 210S1 of the semiconductor layer 210S, a plurality of p-MOS transistors 211 and a plurality of n-MOS transistors 212 configuring the analog circuit are provided. The wiring layer 210T-1 includes a plurality of wirings 213, and has a surface at which a plurality of pad portions 214 is exposed. The wiring layer 210T-2 includes a plurality of wirings 215, and has a surface at which a plurality of pad portions 216 is exposed. For example, the wiring layer 210T-1 and the wiring layer 210T-2 are electrically coupled to each other by a through-wiring 217 passing through the semiconductor layer 210S.

The second layer 220 includes a semiconductor layer 220S having a surface 220S1 and a surface 220S2 forming a pair and being opposed to each other, a wiring layer 220T-1 provided on the surface 220S1 side of the semiconductor layer 220S, and a wiring layer 220T-2 provided on the surface 220S2 side of the semiconductor layer 220S. On the surface 220S1 of the semiconductor layer 220S, a plurality of p-MOS transistors 221 and a plurality of n-MOS transistors 222 configuring the logic circuit are provided. The wiring layer 220T-1 includes a plurality of wirings 223, and has a surface at which a plurality of pad portions 224 is exposed. The wiring layer 220T-2 includes a plurality of wirings 225, and has a surface at which a plurality of pad portions 226 is exposed. For example, the wiring layer 220T-1 and the wiring layer 220T-2 are electrically coupled to each other by a through-wiring 227 passing through the semiconductor layer 220S.

The third layer 230 includes a semiconductor layer 230S having a surface 230S1 and a surface 230S2 forming a pair and being opposed to each other, and a wiring layer 230T provided on the surface 230S1 side of the semiconductor layer 230S. On the surface 230S1 of the semiconductor layer 230S, a plurality of p-MOS transistors 231 and a plurality of n-MOS transistors 232 configuring a circuit including the MEM are provided. The wiring layer 230T includes a plurality of wirings 233, and has a surface at which a plurality of pad portions 234 is exposed.

The semiconductor layers 210S, 220S, and 230S each include, for example, a silicon substrate. In addition, the semiconductor layers 210S, 220S, and 230S may be formed by using semiconductor materials different from each other. For example, it is possible for each of the semiconductor layers 210S, 220S, and 230S to use a semiconductor substrate including germanium (Ge), selenium (Se), carbon (C), or the like. For example, it is possible for each of the semiconductor layers 210S, 220S, and 230S to use a compound semiconductor substrate including silicon germanium (SiGe), gallium arsenide (GaAs), gallium phosphide (GaP), nickel antimonide (NiSb), indium antimonide (InSb), indium arsenide (InAs), indium phosphide (InP), gallium nitride (GaN), silicon carbide (SiC), or indium gallium arsenide (InGaAs). For example, each of the semiconductor layers 210S, 220S, and 230S may be formed by using a one-dimensional material such as a carbon nanotube, or a two-dimensional material such as transition metal dichalcogenide (TMD) or graphene.

Moreover, the plurality of p-MOS transistors 211, 221, and 231 and the plurality of n-MOS transistors 212, 222, and 232 provided in the first layer 210, the second layer 220, and the third layer 230 may be separately created by using different semiconductor materials. For example, SiGe or Ge may be used for the p-MOS transistors 211, 221, and 231, and a Si material may be used for the n-MOS transistors 212, 222, and 232. Alternatively, for example, a Si material may be used for the p-MOS transistors 211, 221, and 231, and GaN, GaAs, nGaAs, or the like may be used for the n-MOS transistors 212, 222, and 232.

The first layer 210 and the second layer 220 are electrically coupled to each other by bonding the plurality of pad portions 216 and 224 exposed at the surfaces of the wiring layer 210T-2 and the wiring layer 220T-1 that face each other. The second layer 220 and the third layer 230 are electrically coupled to each other by bonding the plurality of pad portions 226 and 34 exposed at the surfaces of the wiring layer 220T-2 and the wiring layer 230T-1 that face each other. The sensor substrate 100 and the first CoW layer 200 are electrically coupled to each other by bonding the plurality of pad portions 124 and 214 exposed at the surfaces of the wiring layer 100T and the wiring layer 210T-1 that face each other. Each of the plurality of pad portions 124, 214, 216, 224, 226, and 234 is formed by using, for example, copper (Cu). That is, the sensor substrate 100 and the first CoW layer 200, and the first layer 210, the second layer 220, and the third layer 230 configuring the first CoW layer 200 are electrically coupled to each other by what is called CuCu bonding.

The second CoW layer 300 is mounted at, for example, a position corresponding to the peripheral section 120 of the sensor substrate 100. The second CoW layer 300 is a chip having a single-layer structure including a semiconductor layer 300S and a wiring layer 300T. The semiconductor layer 300S has a surface 300S1 and a surface 300S2 forming a pair and being opposed to each other, and the wiring layer 300T is provided on the surface 300S1 side of the semiconductor layer 300S. In the semiconductor layer 300S, for example, a 3-nm-node logic circuit is formed. On the surface 300S1 of the semiconductor layer 300S, a plurality of p-MOS transistors 311 and a plurality of n-MOS transistors 312 configuring the logic circuit are provided. The wiring layer 300T includes a plurality of wirings 313, and has a surface at which a plurality of pad portions 314 is exposed.

The semiconductor layer 300S includes, for example, a silicon substrate. It is possible for the semiconductor layer 300S to use a semiconductor substrate including germanium (Ge), selenium (Se), carbon (C), or the like. For example, it is possible for the semiconductor layer 300S to use a compound semiconductor substrate including silicon germanium (SiGe), gallium arsenide (GaAs), gallium phosphide (GaP), nickel antimonide (NiSb), indium antimonide (InSb), indium arsenide (InAs), indium phosphide (InP), gallium nitride (GaN), silicon carbide (SiC), or indium gallium arsenide (InGaAs). For example, the semiconductor layer 300S may be formed by using a one-dimensional material such as a carbon nanotube, or a two-dimensional material such as transition metal dichalcogenide (TMD) or graphene.

Moreover, the plurality of p-MOS transistors 311 and the plurality of n-MOS transistors 312 provided in the semiconductor layer 300S may be separately created by using different semiconductor materials. For example, SiGe or Ge may be used for the p-MOS transistors 311, and a Si material may be used for the n-MOS transistors 312. Alternatively, for example, a Si material may be used for the p-MOS transistors 311, and GaN, GaAs, nGaAs, or the like may be used for the n-MOS transistors 312.

The sensor substrate 100 and the second CoW layer 300 are electrically coupled to each other by bonding the plurality of pad portions 124 and 314 exposed at the surfaces of the wiring layer 100T and the wiring layer 300T that face each other. Each of the plurality of pad portions 314 is formed by using, for example, copper (Cu), similarly to the plurality of pad portions 124. That is, the sensor substrate 100 and the second CoW layer 300 are electrically coupled to each other by what is called CuCu bonding.

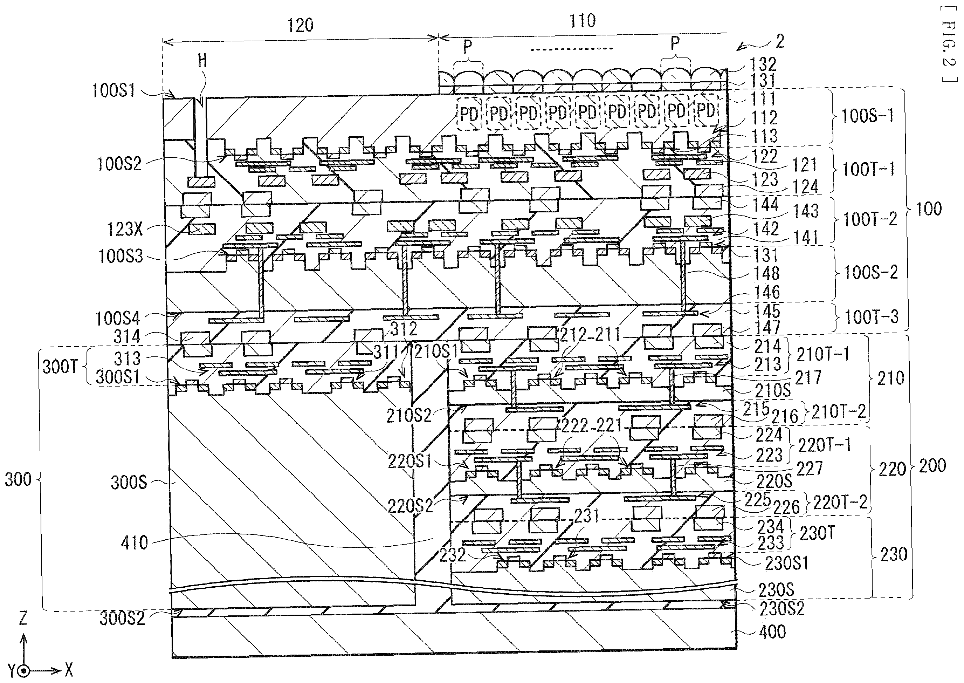

FIG. 2 is a diagram schematically illustrating another example of the cross-sectional configuration of the imaging device according to the embodiment of the present disclosure (an imaging device 2). As illustrated in FIG. 2, the sensor substrate 100 may have a configuration in which a semiconductor layer 100S-1 and a semiconductor layer 100S-2 are stacked. In the semiconductor layer 100S-1, the photodiode PD is formed to be embedded in each of the plurality of sensor pixels P. The semiconductor layer 100S-2 includes a readout circuit that outputs pixel signals on the basis of electric charge output from the sensor pixels P.

On the surface 100S2 of the semiconductor layer 100S-1, for example, the floating diffusions FD, and the plurality of p-MOS transistors 112 and the plurality of n-MOS transistors 113 such as transfer transistors are provided. One floating diffusion FD is provided for each of the sensor pixels P or for a plurality of sensor pixels P. A wiring layer 100T-1 is provided on the surface 100S2 side of the semiconductor layer 100S. The wiring layer 100T-1 includes, within the interlayer insulating layer 121, wirings including the gates of the plurality of p-MOS transistors 112 and the plurality of n-MOS transistors 113 and the wirings 122 and 123 including the pad electrode 123X and the like. At the surface of the wiring layer 100T-1 (specifically, the surface of the interlayer insulating layer 121), the plurality of pad portions 124 to be used for bonding and electrical coupling to the semiconductor layer 100S-2 is exposed.

On a surface 100S3 of the semiconductor layer 100S-2 opposed to the semiconductor layer 100S-1, a plurality of p-MOS transistors and a plurality of n-MOS transistors configuring the readout circuit are provided. A wiring layer 100T-2 is provided on the surface 100S3 side of the semiconductor layer 100S-2. The wiring layer 100T-2 includes, within an interlayer insulating layer 141, wirings 142 and 143 including wirings and the like including gates of the plurality of p-MOS transistors and the plurality of n-MOS transistors. At the surface of the wiring layer 100T-2 (specifically, the surface of the interlayer insulating layer 141), a plurality of pad portions 144 to be used for bonding and electrical coupling to the semiconductor layer 100S-1 is exposed. On a surface 100S4 side of the semiconductor layer 100S-2, a wiring layer 100T-3 including a wiring 146 within an interlayer insulating layer 145 is provided. At the surface of the wiring layer 100T-3 (specifically, the surface of the interlayer insulating layer 145), a plurality of pad portions 147 to be used for bonding and electrical coupling to the first CoW layer 200 and the second CoW layer 300 is exposed. The wiring layer 100T-2 and the wiring layer 100T-3 are electrically coupled to each other by, for example, a through-wiring 148 passing through the semiconductor layer 100S-2.

In the imaging device 2, the sensor substrate 100 and the first CoW layer 200 are electrically coupled to each other by bonding the plurality of pad portions 147 and the plurality of pad portions 214 exposed at the surfaces that face each other, and the sensor substrate 100 and the second CoW layer 300 are electrically coupled to each other by bonding the plurality of pad portions 147 and the plurality of pad portions 314 exposed at the surfaces that face each other.

### [Method of Manufacturing Imaging Device]

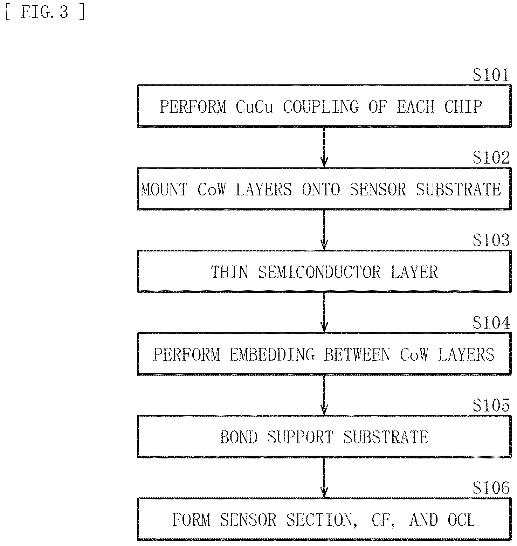

FIG. 3 is a diagram illustrating a flow of a manufacturing process of the imaging devices 1 and 2 illustrated in FIG. 1 and FIG. 2. For example, it is possible to manufacture the imaging devices 1 and 2 as follows.

First, the first layer 210, the second layer 220, and the third layer 230 are coupled to each other by CuCu bonding to form the first CoW layer 200 (Step S101). Next, the sensor substrate 100 and each of the first CoW layer 200 and the second CoW layer 300 are coupled to each other by CuCu bonding to mount the first CoW layer 200 and the second CoW layer 300 onto the sensor substrate 100 (Step S102).

Subsequently, a surface 200SS2 of the first CoW layer 200 and the surface 300S2 of the second CoW layer 300 are polished by, for example, chemical mechanical polishing (CMP) to perform thinning to a predetermined thickness (Step S103). Next, for example, by a chemical vapor deposition (CVD) method, the insulating layer 410 is embedded between the first CoW layer 200 and the second CoW layer 300 (Step S104).

Subsequently, for example, after the surface of 410 provided on the surface 200SS2 of the first CoW layer 200 and the surface 300S2 of the second CoW layer 300 is planarized by CMP, the support substrate 400 is bonded on the surface 200SS2 side of the first CoW layer 200 and the surface 300S2 side of the second CoW layer 300. After that, with a back surface process, the light receiving element 111, the color filter 131, and the light receiving lens 132 are formed on the surface 100S1 side of the sensor substrate 100. As described above, the imaging devices 1 and 2 illustrated in FIG. 1 and FIG. 2 are completed.

### [Example of Coupling of Imaging Device]

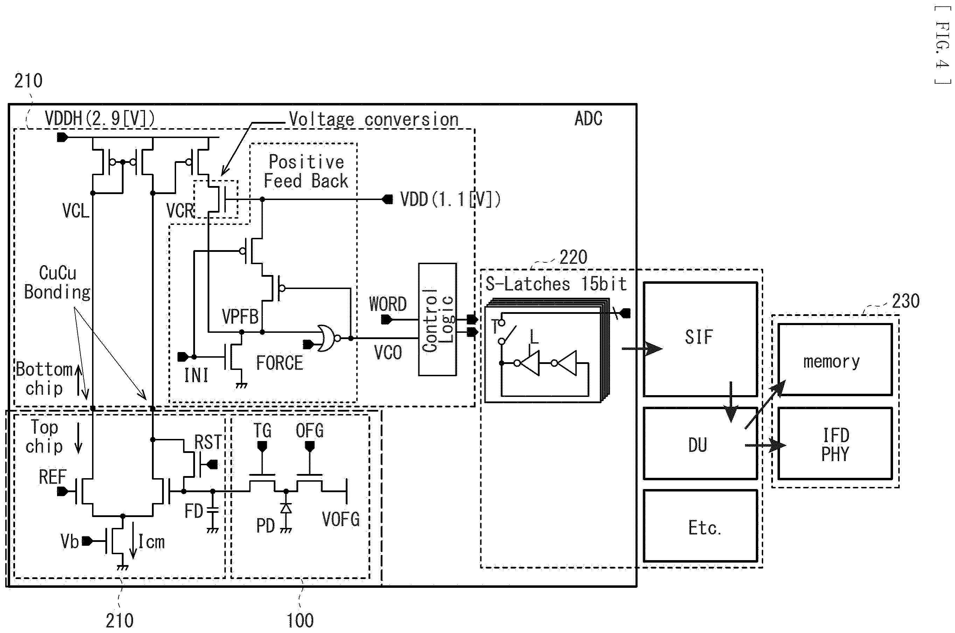

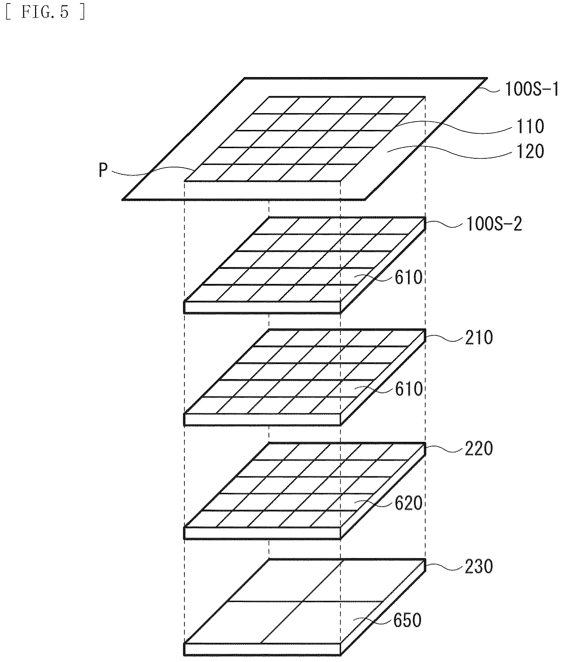

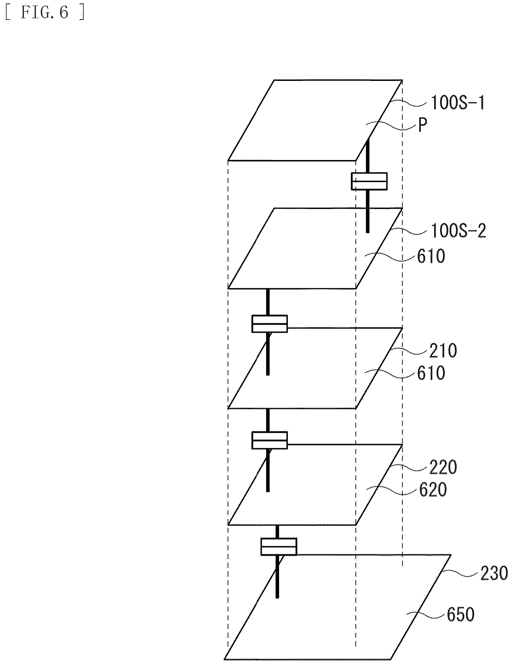

FIG. 4 is a diagram illustrating an example of a circuit configuration of the imaging devices 1 and 2. FIG. 5 and FIG. 6 are exploded perspective diagrams illustrating a mode of coupling in, for example, the pixel array section 110 of the imaging device 2 illustrated in FIG. 2.

The first CoW layer 200 is provided at a position corresponding to the pixel array section 110 of the sensor substrate 100, and includes, as described above, three stacked layers (the first layer 210, the second layer 220, and the third layer 230) that are different in technology node from each other.

In the first layer 210, for example, an analog circuit is formed, together with the semiconductor layer 100S-2 of the sensor substrate 100. The analog circuit has a circuit configuration that amplifies the pixel signals generated in the plurality of sensor pixels P and converts the amplified pixel signals into digital signals. The analog circuit is a portion of, for example, an analog-to-digital converter (ADC) 610 of the imaging device 2 or a control unit that controls each unit in the imaging device 1, and has a circuit configuration to be supplied with a power supply voltage for an analog circuit. Examples of the analog circuit include various transistors (the readout circuit) that read the analog pixel signals from the sensor pixels P, a vertical drive circuit that drives, in units of rows, the sensor pixels P arranged in a two-dimensional matrix manner in row and column directions, a comparator and a counter of the ADC 610, a reference voltage supply unit that supplies a reference voltage to the comparator, a Phase Locked Loop (PLL) circuit, and a load MOS.

In the second layer 220, for example, a logic circuit that corrects and modulates the digital signal obtained by conversion in the analog circuit 210 is formed. As an example, in the second layer 220, a latch circuit 620, a sensor interface (SIF) 630, a digital unit (DU) 640, or the like are formed. In the second layer 220, an application processor (AP) or the like having a circuit configuration that allows machine learning such as a deep neural network (DNN) to be performed may be further formed.

In the third layer 230, for example, a memory 650 such as a DRAM is formed. In addition, in the third layer 230, for example, a circuit section 660 including an interface driver (IFD) and a physical layer (PHY) is formed.

The imaging device 2 has a configuration that allows analog conversion to be performed in units of pixels. Specifically, for example, a signal output from the sensor pixel P is converted in units of pixels in, for example, the 22-nm-node analog circuit of the first layer 210, and correction processing is executed in, for example, the 5-nm-node logic circuit of the second layer 220. In the third layer 230, the memory 650 is formed, and it is possible to link the memory 650 with a learning function such as the DNN.

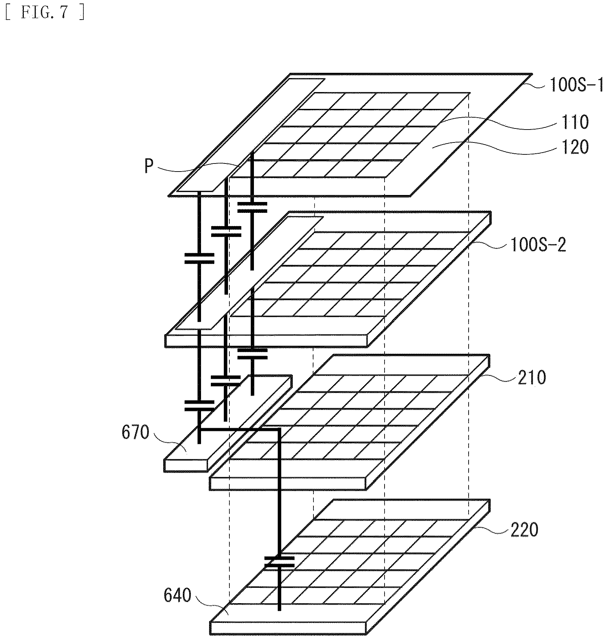

FIG. 7 is an exploded perspective view illustrating a mode of coupling in the peripheral section 120 of the imaging device 2 illustrated in FIG. 2.

The second CoW layer 300 is, as described above, mounted at a position corresponding to the peripheral section 120 of the sensor substrate 100. In the second CoW layer 300, an interface circuit (IF) 670 is formed. The IF 670 has a circuit configuration that outputs data (a digital signal) processed in the logic circuit or the like formed in the second layer 220 of the first CoW layer 200 to the outside. Specifically, the IF 670 is supplied with data processed in the DU 640 formed in the second layer 220 of the first CoW layer 200, and the data is output to the outside via the pad electrode 123X provided in the sensor substrate 100.

### [Actions and Effects]

In the imaging device 1 of the present embodiment, on the surface 100S2 side that is the side opposite to the light entering surface (the surface 100S1) of the sensor substrate 100 on which the plurality of light receiving elements 111 is formed in an array shape, the first CoW layer 200 and the second CoW layer 300 that each include one or a plurality of semiconductor layers being stacked and each including one or a plurality of circuits are mounted side by side in an in-plane direction. This allows a desired circuit chip to be mounted at a desired position. This is hereinafter described.

In recent years, an image sensor having a three-dimensional structure in which a sensor section and a control circuit section are produced with different wafers and stacked has been developed. The image sensor having the three-dimensional structure tends to be further provided with a signal processing circuit for correction within the sensor or the like or to be increased in the number of memories required for holding the processing information. In order to cope with this issue, an image sensor having mounted thereon a single-layer chip in which various functions are collected in one chip, or an image sensor having mounted thereon three or more stacked chips has been proposed.

However, the image sensor having a single-layer chip mounted thereon has a disadvantage in that it is unable to mount a desired circuit from restrictions in mountable circuit area, and thus it is unable to implement a desired function. Further, in a case where the number of mountable circuits is increased by simply increasing the number of stacked chips, there arise issues such as increase in cost and electric power, or deterioration in characteristics and reduction in reliability due to heat generation caused by close arrangement of the stacked circuits. In addition, there is a possibility that the signal is delayed or the power consumption is increased due to the increase in wiring distance between the chips.

In contrast, in the present embodiment, as described above, on the surface 100S2 side that is the side opposite to the light entering surface (the surface 100S1) of the sensor substrate 100, the first CoW layer 200 and the second CoW layer 300 that each include the one or the plurality of semiconductor layers being stacked and each including the one or the plurality of circuits are mounted side by side in the in-plane direction. As an example, at a position corresponding to the pixel array section 110 of the sensor substrate 100, the first CoW layer 200 including three stacked semiconductor layers (the first layer 210, the second layer 220, and the third layer 230) that are different in technology node from each other and each include one or a plurality of circuits is mounted. At a position corresponding to the peripheral section 120 of the sensor substrate 100, the second CoW layer 300 including a single layer (a semiconductor layer 310S) is mounted.

As described above, at a position at which a large circuit area is required, a CoW layer (for example, the first CoW layer 200) including a plurality of stacked semiconductor layers is mounted, and at a position at which the required circuit area is small, a CoW layer (for example, the second CoW layer 300) including a single layer or a small number of stacked layers is mounted. This makes it possible to suppress the increase in cost while a desired circuit operation is achieved.

As described above, in the imaging devices 1 and 2 according to the present embodiment, it is possible to achieve both of high functionality and reduction in cost.

Further, in the imaging devices 1 and 2 according to the present embodiment, a CoW layer including a plurality of stacked semiconductor layers is selectively mounted only at a position at which a large circuit area is required, and hence it is possible to reduce heat generated due to close arrangement of the stacked circuits. For example, in the imaging devices 1 and 2 according to the present embodiment, the chip (the second CoW layer 300) including the IF circuit 670 that is large in heat generation is formed to have a single-layer structure, and thus it is possible to dissipate heat generated in the IF circuit 670 to the support substrate 400. This allows reduction in occurrence of circuit failure due to heat generation of the chip.

Moreover, in the imaging devices 1 and 2 according to the present embodiment, at a position at which a large circuit area is required, a CoW layer including a plurality of stacked semiconductor layers is mounted, and hence, as compared with a case of mounting the semiconductor layers side by side in a planar direction, it is possible to reduce the wiring distance. This makes it possible to reduce delay of a signal or increase of a consumption electrode.

Still further, in the imaging devices 1 and 2 according to the present embodiment, it is possible to manufacture the CoW layers having a plurality of functions in parallel in terms of time, and hence it is possible to reduce the time required for the manufacture.

In the following, Modification Examples (Modification Examples 1 to 7) of the above-described embodiment are described. It is to be noted that, in the following description, the same components as those in the above-described embodiment are denoted by the same reference symbols, and description thereof is omitted as appropriate.

### <2. Modification Examples>

### (2-1. Modification Example 1)

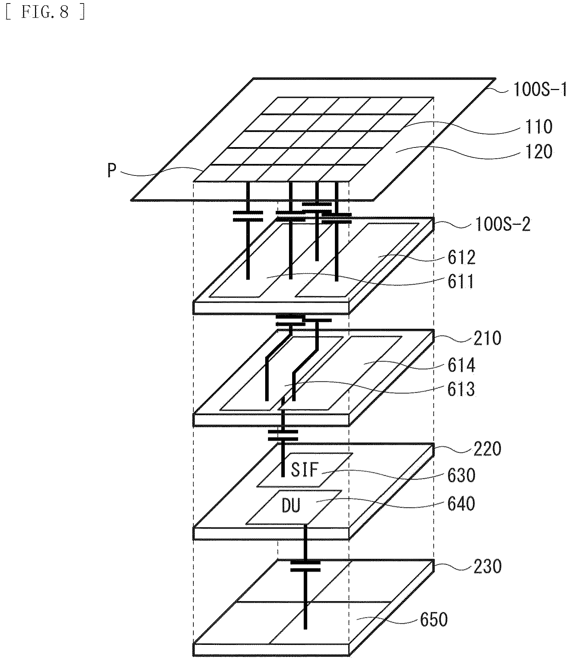

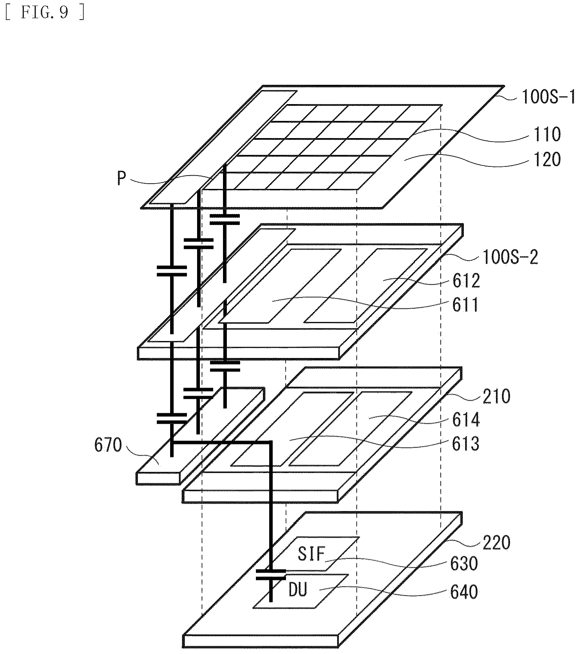

FIG. 8 is an exploded perspective view illustrating a mode of coupling in the pixel array section 110 of the imaging device (for example, the imaging device 2) according to Modification Example 1 of the present disclosure. FIG. 9 is an exploded perspective view illustrating a mode of coupling in the peripheral section 120 of the imaging device (for example, the imaging device 2) according to Modification Example 1 of the present disclosure.

In the above-described embodiment, an example in which analog conversion is possible in units of pixels has been described, but the present disclosure is not limited thereto. In this modification example, each sensor pixel P and the ADC 610 are coupled to each other in units of circuit blocks in place of in units of pixels.

The imaging device 2 of this modification example includes a plurality of vertical drive circuits, and a plurality of (in this case, four) AD blocks 611, 612, 613, and 614 serving as the ADC 610. The AD blocks 611 and 612 are provided in the semiconductor layer 100S-2 of the sensor substrate 100, and the AD blocks 613 and 614 are provided in the semiconductor layer 210S of the first layer 210 of the first CoW layer.

The plurality of sensor pixels P disposed in an array shape in the pixel array section 110 is divided into a plurality of blocks (for example, four pixel blocks), and the pixel blocks and the AD blocks 611, 612, 613, and 614 are respectively coupled to each other via vertical signal lines. The pixel signal output from each of the AD blocks 611, 612, 613, and 614 is supplied to the SIF 630 and the DU 640 provided in the second layer 220 in order.

As described above, in this modification example, the sensor pixels P and the ADC 610 are coupled to each other in units of circuit blocks. This allows the imaging device 2 to achieve high-speed drive and complicated drive in addition to the effects similar to those in the above-described embodiment.

Further, in the imaging device 2 of this modification example, the plurality of AD blocks (the AD blocks 611, 612, 613, 614) is disposed separately to the plurality of semiconductor layers (for example, the semiconductor layer 100S-2 and the semiconductor layer 210S), and hence it is possible to perform high-speed drive and complicated drive without increasing the size of the device.

### (2-2. Modification Example 2)

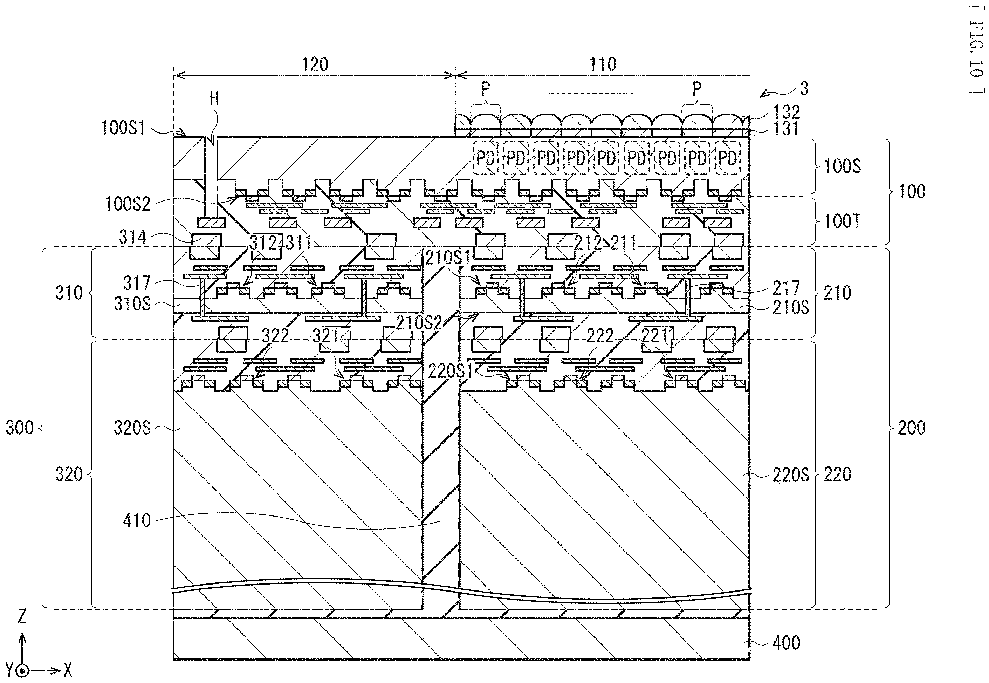

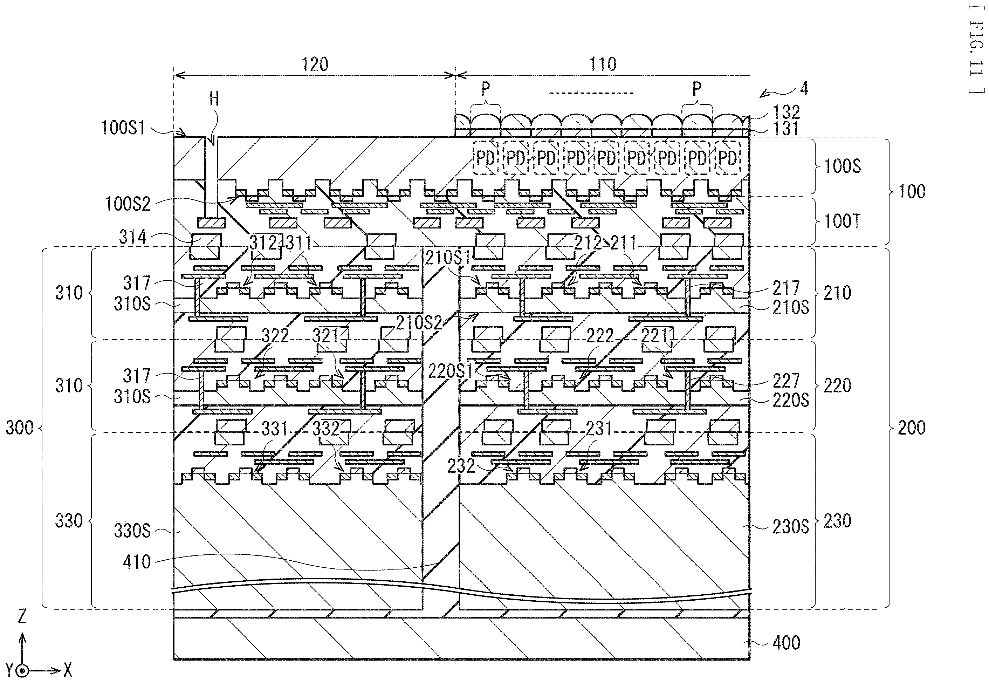

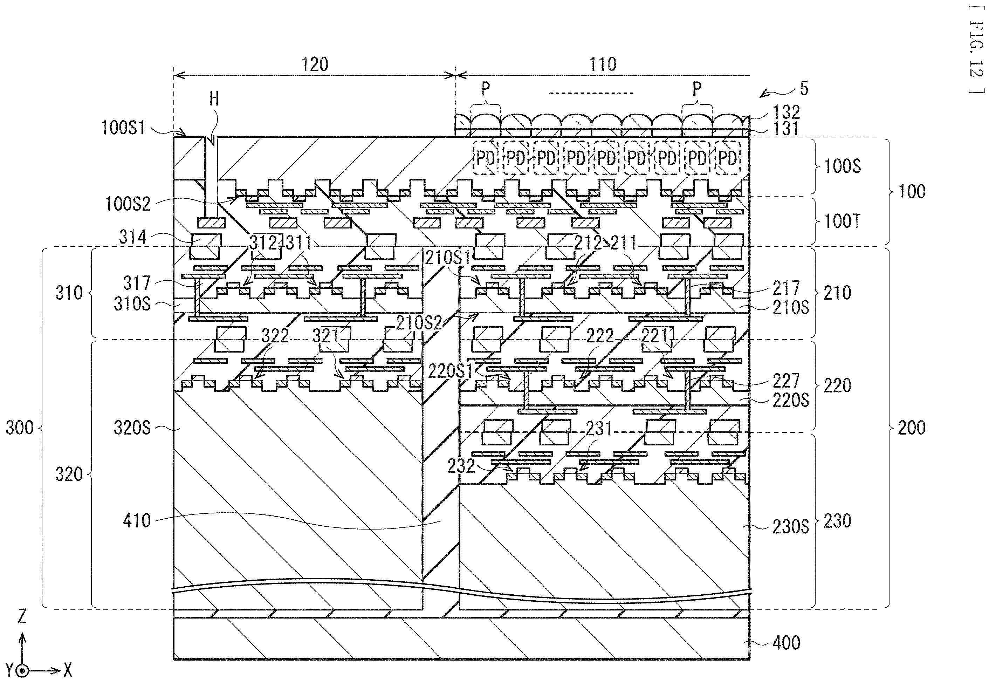

FIG. 10 is a diagram schematically illustrating an example of a cross-sectional configuration of an imaging device (an imaging device 3) according to the embodiment of the present disclosure. FIG. 11 is a diagram schematically illustrating an example of a cross-sectional configuration of an imaging device (an imaging device 4) according to the embodiment of the present disclosure. FIG. 12 is a diagram schematically illustrating an example of a cross-sectional configuration of an imaging device (an imaging device 5) according to the embodiment of the present disclosure.

In the above-described embodiment, description has been given of an example in which, on the surface 100S2 side of the sensor substrate 100, the first CoW layer 200 including three stacked layers (the first layer 210, the second layer 220, and the third layer 230) and the second CoW layer 300 including a single layer are mounted side by side, but the number of semiconductor layers configuring each of the first CoW layer 200 and the second CoW layer 300 is not limited thereto. In the imaging device 3 of this modification example, on the surface 100S2 side of the sensor substrate 100, the first CoW layer 200 including two stacked layers (the first layer 210 and the second layer 220) and the second CoW layer 300 including two stacked layers (a first layer 310 and a second layer 320) are mounted side by side. In the imaging device 4, on the surface 100S2 side of the sensor substrate 100, the first CoW layer 200 including three stacked layers (the first layer 210, the second layer 220, and the third layer 230) and the second CoW layer 300 including three stacked layers (the first layer 310, the second layer 320, and a third layer 330) are mounted side by side. In the imaging device 5, on the surface 100S2 side of the sensor substrate 100, the first CoW layer 200 including three stacked layers (the first layer 210, the second layer 220, and the third layer 230) and the second CoW layer 300 including two stacked layers (the first layer 310 and the second layer 320) are mounted side by side.

The second CoW layer 300 has, as described above, a chip structure in which two or three semiconductor layers (the first layer 310 and the second layer 320, or the first layer 310, the second layer 320, and the third layer 330) are stacked. The first layer 310, the second layer 320, and the third layer 330 may each include one or a plurality of circuits having the same technology node, or one or a plurality of circuits different in technology node from each other.

The first layer 310 includes the semiconductor layer 310S having a pair of opposing surfaces, and a wiring layer is provided on each of the pair of surfaces of the semiconductor layer 310S. The second layer 320 includes a semiconductor layer 320S having a pair of opposing surfaces, and a wiring layer is provided on each of the pair of surfaces of the semiconductor layer 320S. The third layer 330 includes a semiconductor layer 330S having a pair of opposing surfaces, and a wiring layer is provided on each of the pair of surfaces of the semiconductor layer 330S. In the semiconductor layer 310S, the plurality of p-MOS transistors 311 and the plurality of n-MOS transistors 312 are provided. In the semiconductor layer 320S, a plurality of p-MOS transistors 322 and a plurality of n-MOS transistors 322 are provided. In the semiconductor layer 330S, a plurality of p-MOS transistors 332 and a plurality of n-MOS transistors 332 are provided. A plurality of pad portions is exposed at the surfaces of the wiring layers that face each other, and those pad portions are bonded to each other to electrically couple the first layer 310 and the second layer 220 to each other by hybrid bonding and electrically couple the second layer 220 and the third layer 230 to each other by hybrid bonding, similarly to the first CoW layer 200. The wiring layers respectively provided on the pair of surfaces of the semiconductor layer 310S are electrically coupled to each other by a through-wiring 317 passing through the semiconductor layer 310S, and the wiring layers respectively provided on the pair of surfaces of the semiconductor layer 320S are electrically coupled to each other by a through-wiring 327 passing through the semiconductor layer 310S.

Each of the semiconductor layers 310S, 320S, and 330S includes, for example, a silicon substrate. It is possible for each of the semiconductor layers 310S, 320S, and 330S to use a semiconductor substrate including germanium (Ge), selenium (Se), carbon (C), or the like. For example, it is possible for the semiconductor layer 300S to use a compound semiconductor substrate including silicon germanium (SiGe), gallium arsenide (GaAs), gallium phosphide (GaP), nickel antimonide (NiSb), indium antimonide (InSb), indium arsenide (InAs), indium phosphide (InP), gallium nitride (GaN), silicon carbide (SiC), or indium gallium arsenide (InGaAs). For example, the semiconductor layer 300S may be formed by using a one-dimensional material such as a carbon nanotube, or a two-dimensional material such as transition metal dichalcogenide (TMD) or graphene.

Moreover, the plurality of p-MOS transistors 311, 322, and 332 and the plurality of n-MOS transistors 312, 322, and 332 provided in the semiconductor layers 310S, 320S, and 330S may be separately created by using different semiconductor materials. For example, SiGe or Ge may be used for the p-MOS transistors 311, 322, and 332, and a Si material may be used for the n-MOS transistors 312, 322, and 332. Alternatively, for example, a Si material may be used for the p-MOS transistors 311, 322, and 332, and GaN, GaAs, nGaAs, or the like may be used for the n-MOS transistors 312, 322, and 332.

As described above, the first CoW layer 200 and the second CoW layer 300 mounted on the surface 100S2 side of the sensor substrate 100 may both include two or three stacked semiconductor layers as in the imaging devices 3 and 4 illustrated in FIGs. 10 and 11. Further, as in the imaging device 5 illustrated in FIG. 12, the first CoW layer 200 may include three stacked semiconductor layers, and the second CoW layer 300 may include two stacked semiconductor layers. In any case, it is possible for the imaging devices 3 to 5 of this modification example to obtain effects similar to those in the above-described embodiment.

In addition, the first CoW layer 200 may include two stacked semiconductor layers, and the second CoW layer 300 may include a single layer, or the first CoW layer 200 and the second CoW layer 300 may each include four or more stacked semiconductor layers.

### (2-3. Modification Example 3)

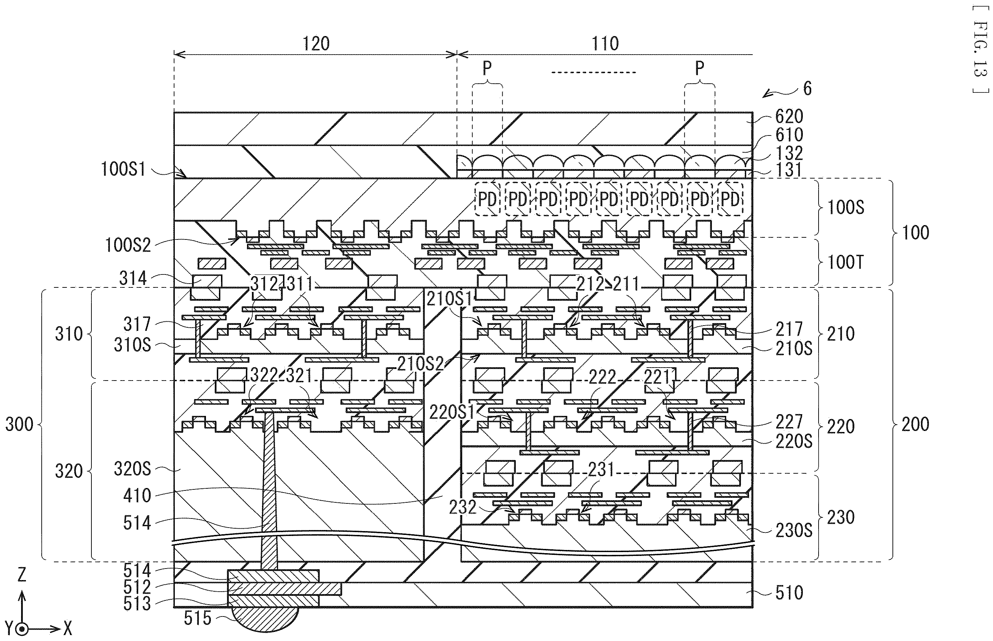

FIG. 13 is a diagram schematically illustrating an example of a cross-sectional configuration of an imaging device (an imaging device 6) according to the embodiment of the present disclosure.

In the above-described embodiment, description has been given of an example in which coupling is established from the surface 100S1 side to the outside via the pad electrode 123X provided within the wiring layer 100T of the sensor substrate 100 and exposed by the opening H, but the present disclosure is not limited thereto. In the imaging device 6 of this modification example, a terminal (a bump 515) for external coupling is provided on the surface of the first CoW layer 200 and the second CoW layer 300 on a side opposite to the surface facing the sensor substrate 100.

In the imaging device 6, the insulating layer 410 and an insulating layer 510 are stacked on the surfaces of the first CoW layer 200 and the second CoW layer 300 on the side opposite to the surfaces facing the sensor substrate 100. Conductive films 511, 512, and 513 are embedded in the insulating layers 410 and 510. For example, a through-electrode 514 that passes through the semiconductor layer 320S is coupled to the conductive film 511 embedded in the insulating layer 410, and the conductive film 513 is exposed at the surface of the insulating layer 510. On the conductive film 513, the bump 515 to be used for external coupling is formed.

It is to be noted that, in the imaging device 6, in order to keep the mechanical strength as a chip, a resin layer 610 and a glass substrate 620 that have optical transparency may be provided on the surface 100S1 side of the sensor substrate 100.

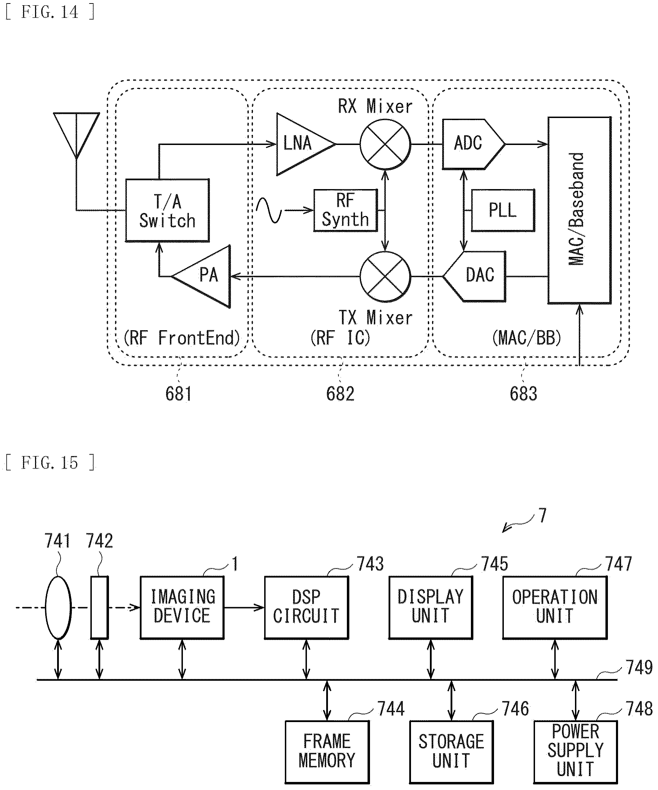

FIG. 14 is a diagram illustrating an example of a configuration of circuit blocks that are to be mounted in the first CoW layer 200 and the second CoW layer 300 with a communication chip being mixed. In the first CoW layer 200 and the second CoW layer 300 mounted on the surface 100S2 side of the sensor substrate 100, for example, an analog front-end (AFE) circuit section 681 is formed in the second layer 320 of the second CoW layer 300, a radio frequency integrated circuit (RF-IC) 682 is formed in the first layer 310 of the second CoW layer 300, and a baseband (BB) circuit 683 is formed in the second layer 220 of the first CoW layer 200. At this time, it is possible to use a compound semiconductor substrate for the semiconductor layer 320S of the second layer 320 in which the AFE circuit section 681 is formed. It is possible to use a silicon substrate for the semiconductor layer 310S of the first layer 310 in which the RF-IC 682 is formed.

As described above, in a case where an antenna is formed below the sensor substrate 100, as in the imaging device 6 of this modification example, it is preferred to provide the terminal for external coupling (the bump 515) on the surface of the second CoW layer 300 on a side opposite to the surface facing the sensor substrate 100, and provide, on the surface 100S1 side of the sensor substrate 100, the resin layer 610 and the glass substrate 620 having optical transparency.

### (2-4. Modification Example 4)

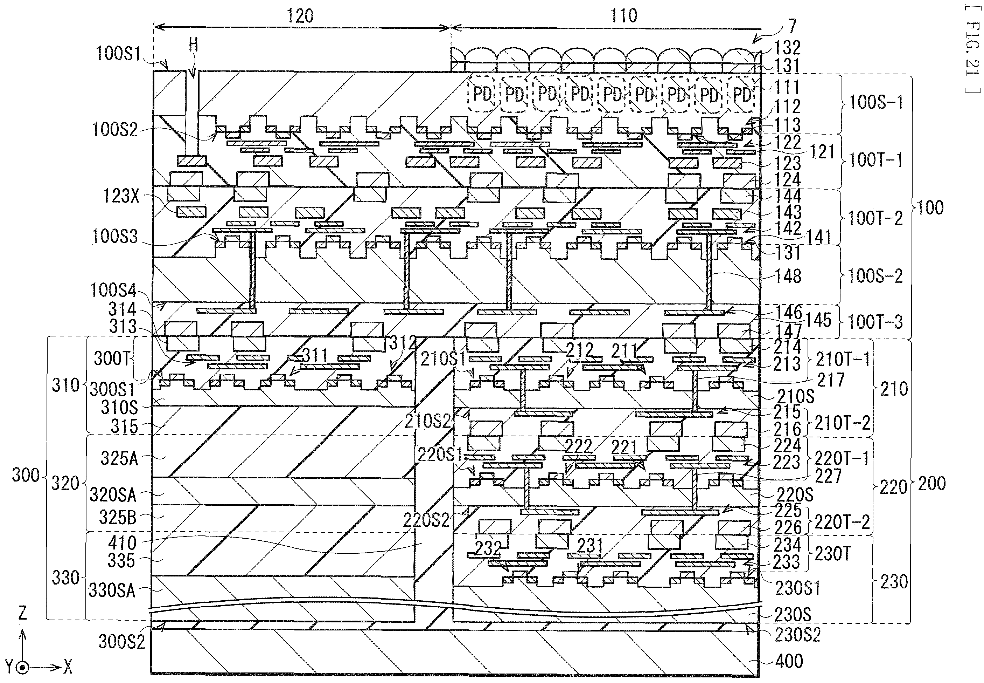

FIG. 21 is a diagram schematically illustrating an example of a cross-sectional configuration of an imaging device (an imaging device 7) according to Modification Example 4 of the present disclosure.

In the above-described embodiment, description has been given of an example in which the thickness of the semiconductor layer 300S configuring the second CoW layer 300 is set as a thick film to match the thickness of the first CoW layer 200 including three layers (the first layer 210, the second layer 220, and the third layer 230), but the present disclosure is not limited thereto. In the imaging device 7 of this modification example, on the first layer 310 of the second CoW layer 300, the second layer 320 and the third layer 330 respectively including semiconductor layers 320SA and 330SA serving as dummies are stacked to adjust the height to match the semiconductor layers 210S, 220S, and 230S of the first layer 210, the second layer 220, and the third layer 230 configuring the first CoW layer 200. Except for this point, the imaging device 7 has a configuration substantially similar to that of the imaging device 2 of the above-described embodiment.

The second CoW layer 300 has a chip structure including, similarly to the first CoW layer 200, a plurality of stacked semiconductor layers (in this case, the first layer 310, the second layer 320, and the third layer 330). The first layer 310 includes the semiconductor layer 310S having a pair of opposing surfaces, and the wiring layer 300T is provided on a surface 200S1 side of the pair of surfaces of the semiconductor layer 310S. In the semiconductor layer 310S, the plurality of p-MOS transistors 311 and the plurality of n-MOS transistors 312 are provided. The second layer 320 includes the semiconductor layer 320SA having a pair of opposing surfaces, and insulating layers 325A and 325B are respectively provided on the pair of surfaces of the semiconductor layer 320SA. The third layer 330 includes a semiconductor layer 330SA having a pair of opposing surfaces, and an insulating layer 325 is provided on the surface of the semiconductor layer 330SA opposed to the second layer 220. The semiconductor layers 320SA and 330SA are dummy semiconductor layers as described above, and p-MOS transistors and n-MOS transistors are not provided unlike the semiconductor layer 310S. The first layer 310 and the second layer 320 are bonded to each other by an insulating layer 315 and the insulating layer 325A, and the second layer 320 and the third layer 330 are bonded to each other by the insulating layer 325B and an insulating layer 335.

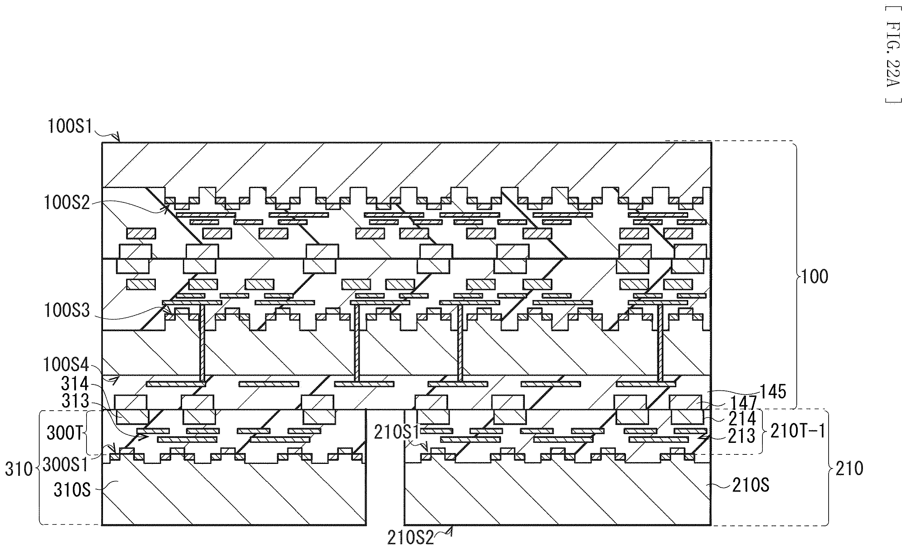

For example, it is possible to manufacture the imaging device 7 as follows. FIG. 22A to FIG. 22H are diagrams illustrating an example of a manufacturing process of the imaging device 7.

First, as illustrated in FIG. 22A, each of the first layer 210 of the first CoW layer 200 and the first layer 310 of the second CoW layer 300 is coupled to the sensor substrate 100 by CuCu bonding.

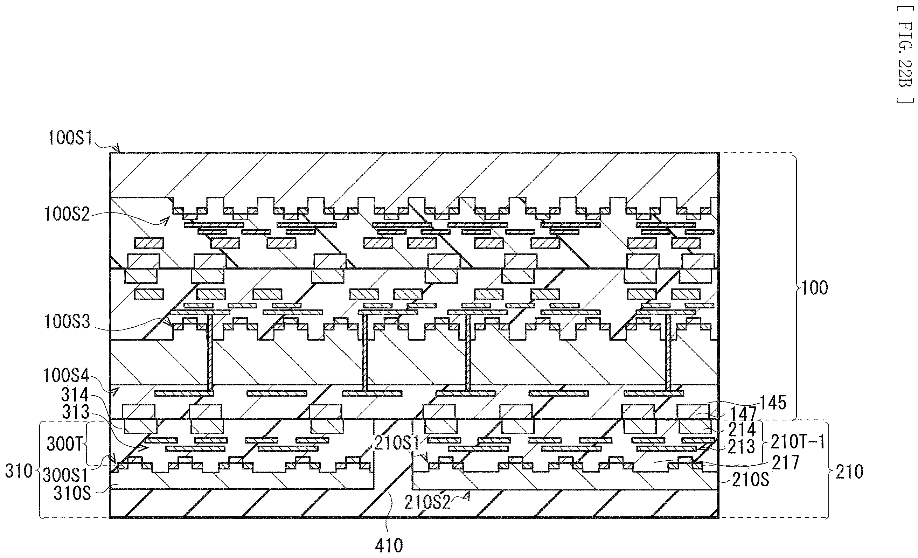

Next, as illustrated in FIG. 22B, the semiconductor layers 210S and 310S respectively configuring the first layers 210 and 310 of the first CoW layer 200 and the second CoW layer 300 are thinned to a predetermined thickness by, for example, polishing by CMP. Subsequently, as illustrated in FIG. 22B, for example, by a CVD method, the insulating layer 410 is embedded between the semiconductor layer 210S and the semiconductor layer 310S.

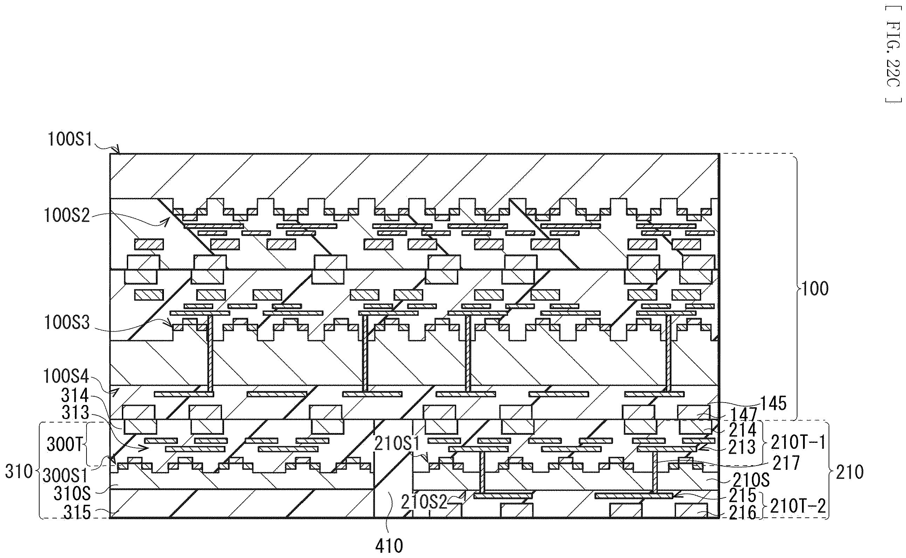

Next, as illustrated in FIG. 22C, for example, after the insulating layer 410 formed on the semiconductor layers 210S and 310S is removed by polishing by CMP, the wiring layer 210T-2 is formed on the semiconductor layer 210S, and the insulating layer 315 is formed on the semiconductor layer 310S.

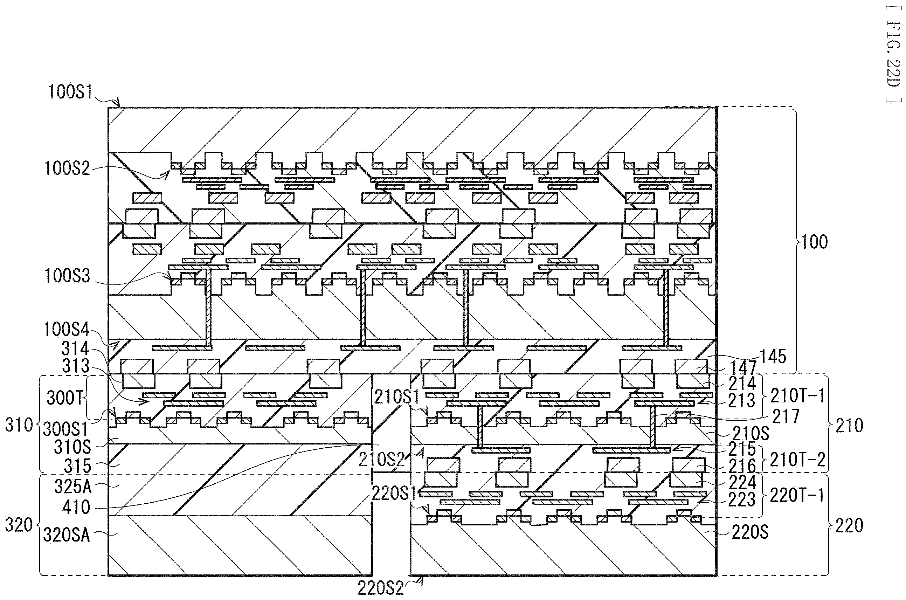

Subsequently, as illustrated in FIG. 22D, onto the first layers 210 and 310, the second layers 220 and 320 are respectively coupled by CuCu bonding.

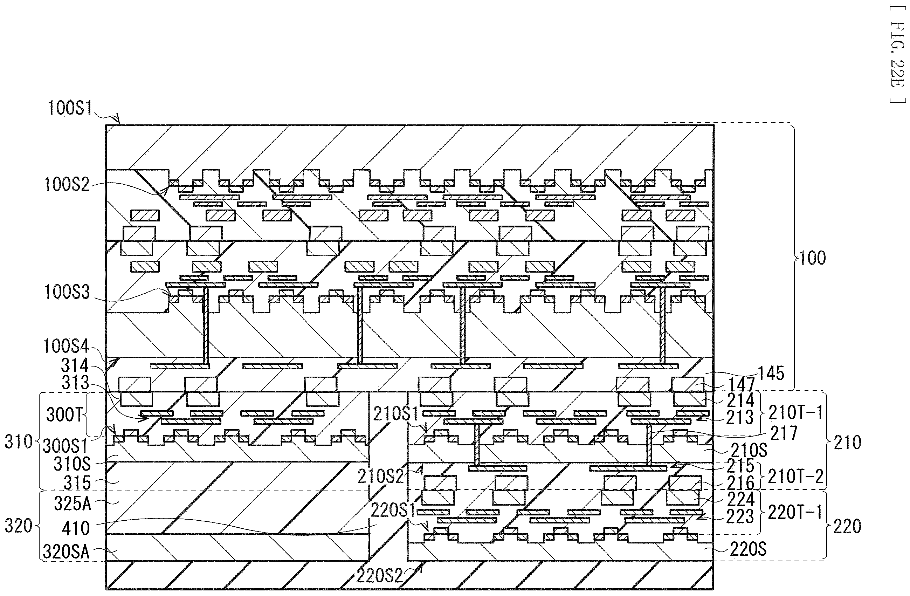

Next, as illustrated in FIG. 22E, the semiconductor layers 220S and 320SA respectively configuring the second layers 220 and 320 of the first CoW layer 200 and the second CoW layer 300 are thinned to a predetermined thickness by, for example, polishing by CMP. Subsequently, as illustrated in FIG. 22E, for example, by a CVD method, the insulating layer 410 is embedded between the semiconductor layer 220S and the semiconductor layer 320SA.

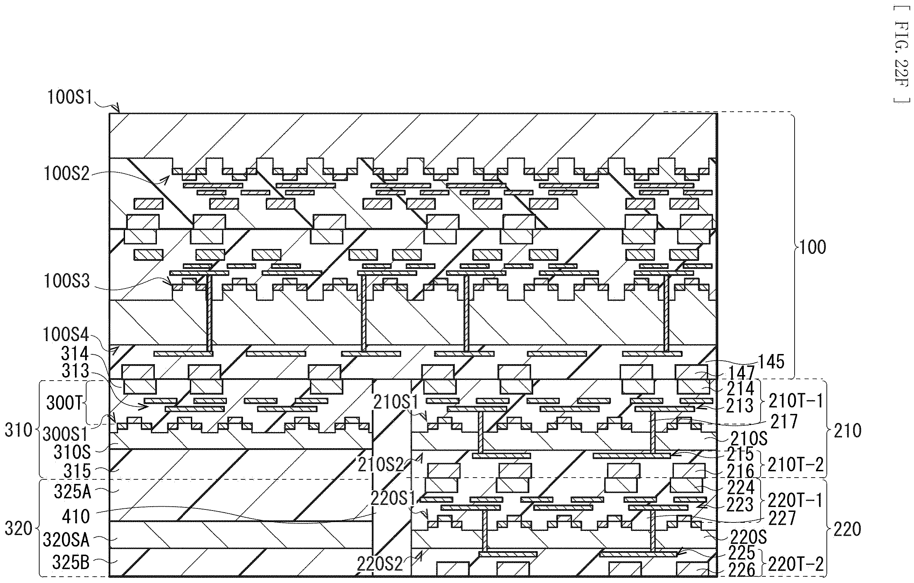

Next, as illustrated in FIG. 22F, for example, after the insulating layer 410 formed on the semiconductor layers 220S and 320SA is removed by polishing by CMP, the wiring layer 220T-2 is formed on the semiconductor layer 220S, and the insulating layer 325B is formed on the semiconductor layer 320SA.

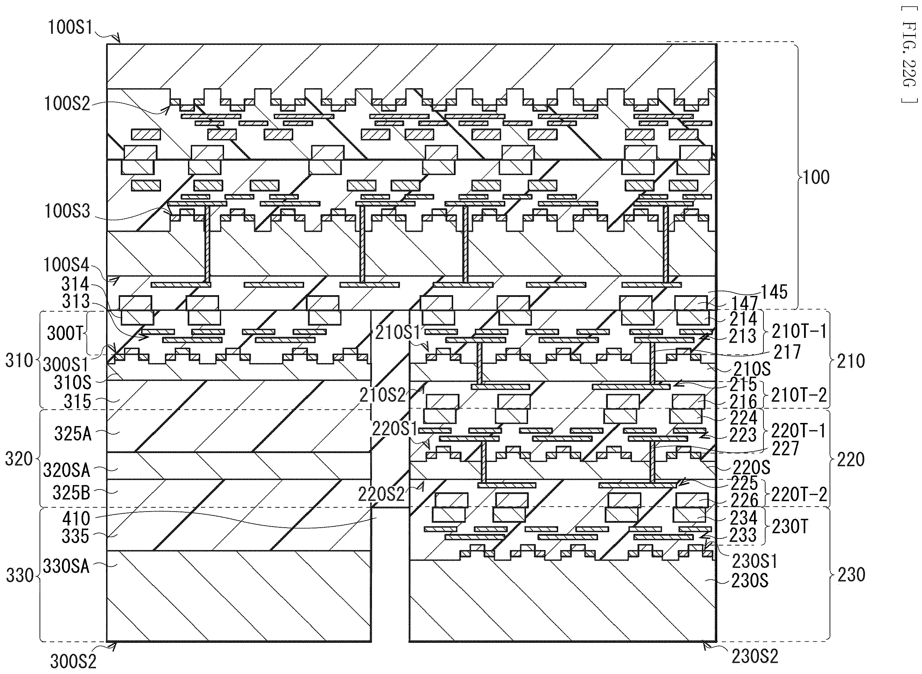

Subsequently, as illustrated in FIG. 22G, onto the second layers 220 and 320, the third layers 230 and 330 are respectively coupled by CuCu bonding.

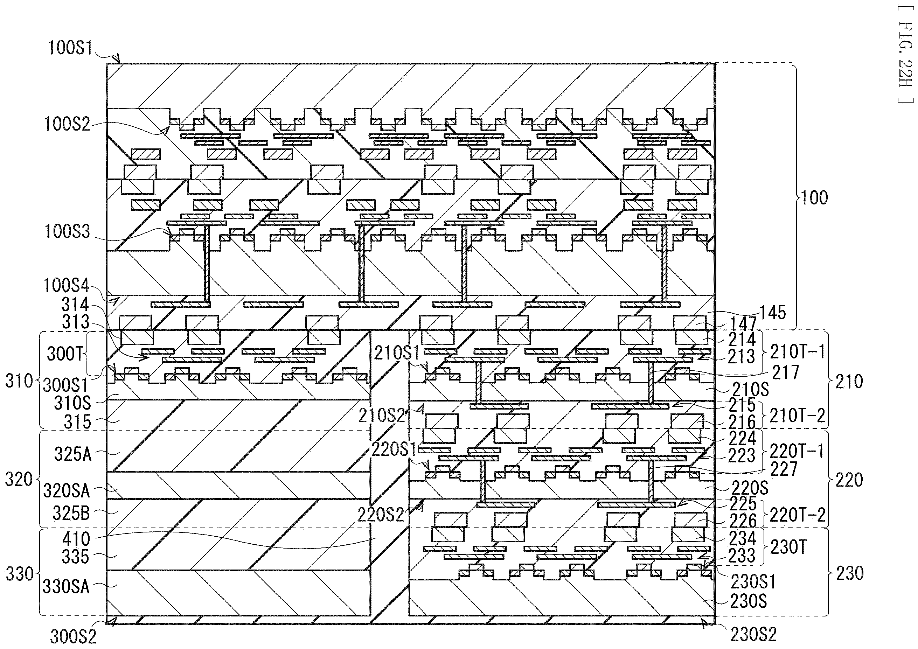

Next, as illustrated in FIG. 22H, the semiconductor layers 230S and 330SA configuring the third layers 230 and 330 of the first CoW layer 200 and the second CoW layer 300 are thinned to a predetermined thickness by, for example, polishing by CMP. Subsequently, as illustrated in FIG. 22H, for example, by a CVD method, the insulating layer 410 is embedded between the semiconductor layer 230S and the semiconductor layer 330SA. After that, the support substrate 400 is bonded on the insulating layer 410, and then, by a back surface process, the light receiving element 111, the color filter 131, and the light receiving lens 132 are formed on the surface 100S1 side of the sensor substrate 100. In this manner, the imaging device 7 illustrated in FIG. 21 is completed.

It is to be noted that the manufacturing process of the imaging device 7 is not limited thereto. For example, as in the above-described embodiment, the first layer 210, the second layer 220, and the third layer 230 configuring the first CoW layer 200 may be coupled to each other and the first layer 310, the second layer 320, and the third layer 330 configuring the second CoW layer 300 may be coupled to each other to form the first CoW layer 200 and the second CoW layer 300 in advance, and then the sensor substrate 100, the first CoW layer 200, and the second CoW layer 300 may be coupled to each other by CuCu bonding.

As described above, in the imaging device 7 of this modification example, the second layer 320 and the third layer 330 respectively including the dummy semiconductor layers 320SA and 330SA are stacked on the surface 300S2 side of the first layer 310 of the second CoW layer 300 to adjust the height to match the respective semiconductor layers 210S, 220S, and 230S of the first layer 210, the second layer 220, and the third layer 230 configuring the first CoW layer 200. This allows the imaging device 7 of this modification example to achieve, in addition to the effects of the above-described embodiment, easiness in planarization by grinding because of alignment in heights of the semiconductor layer 210S of the first layer 210, the semiconductor layer 220S of the second layer 220, and the semiconductor layer 230S of the third layer 230 configuring the first CoW layer 200 and heights of the semiconductor layer 310S of the first layer 310, the semiconductor layer 320SA of the second layer 320, and the semiconductor layer 330SA of the third layer 330 configuring the second CoW layer 300.

Further, in the imaging device 7 of this modification example, as described above, the first CoW layer 200 and the second CoW layer 300 have the same layer configuration of the semiconductor layers, and hence it is possible to match the thermal expansion coefficients of the first CoW layer 200 and the second CoW layer 300. Thus, as compared with the imaging device 1 of the above-described embodiment, it is possible for the imaging device 7 of this modification example to improve the heat dissipation performance and the strength.

Moreover, in the imaging device 7 of this modification example, onto the sensor substrate 100, the first layers 210 and 310, the second layers 220 and 320, and the third layers 230 and 330 of the first CoW layer 200 and the second CoW layer 300 are stacked in the stated order while aligning the heights of the respective layers, and hence the embedment depth of the insulating layer 410 is shallow. Thus, as compared with the case where, as in the above-described embodiment, after the first CoW layer 200 and the second CoW layer 300 are formed in advance, the sensor substrate 100 and each of the first CoW layer 200 and the second CoW layer 300 are coupled to each other by CuCu bonding, for example, it becomes easier to planarize the insulating layer embedded between the first CoW layer 200 and the second CoW layer 300.

### (2-5. Modification Example 5)

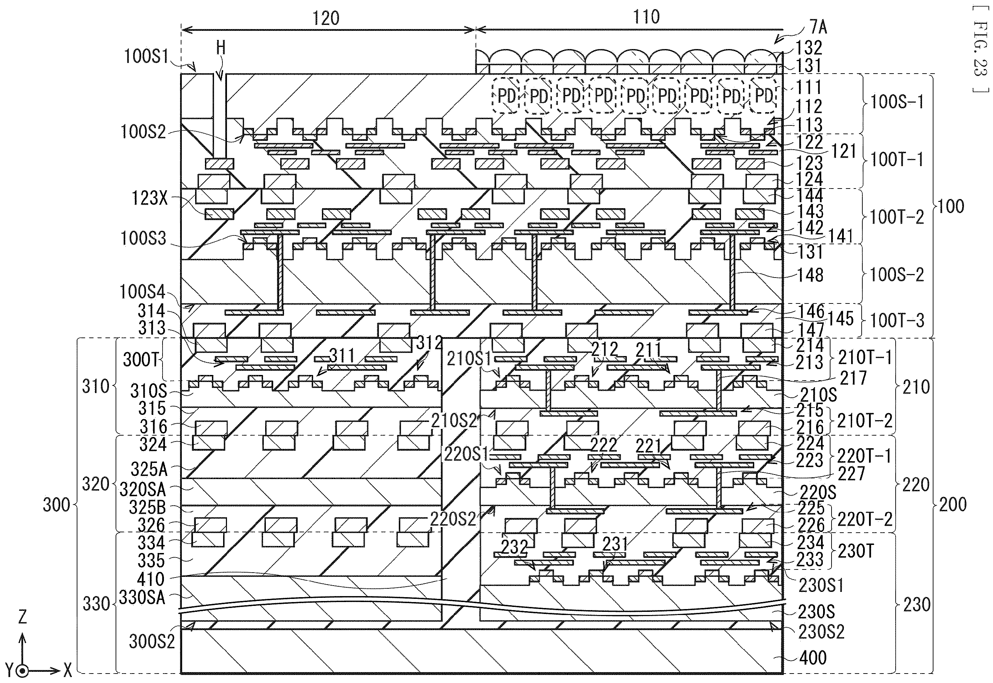

FIG. 23 is a diagram schematically illustrating an example of a cross-sectional configuration of an imaging device (an imaging device 7A) according to Modification Example 5 of the present disclosure.

In Modification Example 4 above, description has been given of an example in which the first layer 310 and the second layer 320 configuring the second CoW layer 300 are coupled to each other by the insulating layer 315 and the insulating layer 325A, and the second layer 320 and the third layer 330 configuring the second CoW layer 300 are coupled to each other by the insulating layer 325B and the insulating layer 335, but the present disclosure is not limited thereto. In the imaging device 7A of this modification example, on surfaces of the insulating layers 315, 325A, 325B, and 335 to be bonded to each other, a plurality of pad portions 316, 324, 326, and 334 are respectively provided, and are coupled to each other by hybrid bonding. Except for this point, the imaging device 7A has a configuration substantially similar to that of the above-described imaging device 7 of Modification Example 4.

As described above, in the imaging device 7A of this modification example, the first layer 310 and the second layer 320 configuring the second CoW layer 300 are coupled to each other by hybrid bonding, and the second layer 320 and the third layer 330 configuring the second CoW layer 300 are coupled to each other by hybrid bonding. Even in such a configuration, it is possible for the imaging device 7A of this modification example to obtain effects similar to those of Modification Example 7 described above.

### (2-6. Modification Example 6)

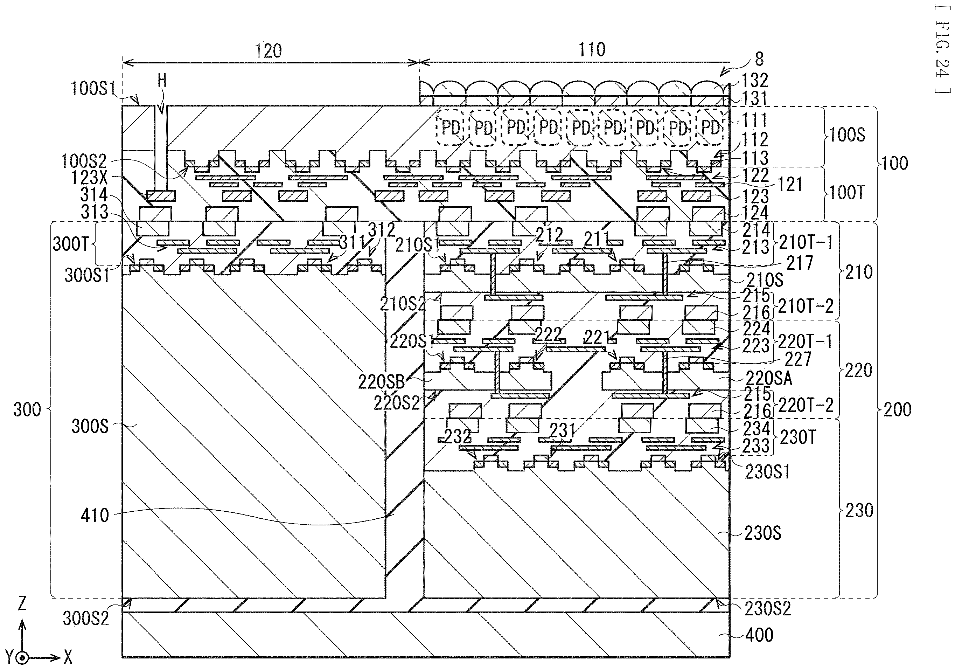

FIG. 24 is a diagram schematically illustrating an example of a cross-sectional configuration of an imaging device (an imaging device 8) according to Modification Example 6 of the present disclosure.

In the above-described embodiment, description has been given of an example in which the semiconductor layer 210S of the first layer 210, the semiconductor layer 220S of the second layer 220, and the semiconductor layer 230S of the third layer 230 each configuring the first CoW layer 200 have the same size as each other, but the present disclosure is not limited thereto. In the imaging device 8 of this modification example, the second layer 220 configuring the first CoW layer 200 includes two semiconductor layers 220A and 220B that are smaller than the semiconductor layer 210S of the first layer 210 and the semiconductor layer 230S of the third layer 230. Except for this point, the imaging device 8 has a configuration substantially similar to that of the imaging device 1 of the above-described embodiment.

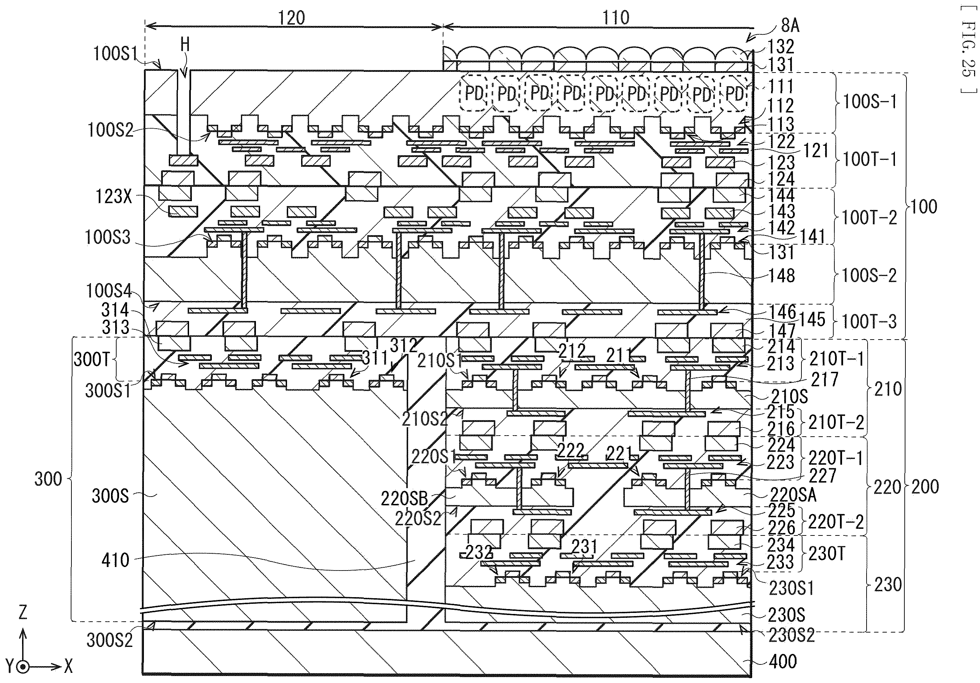

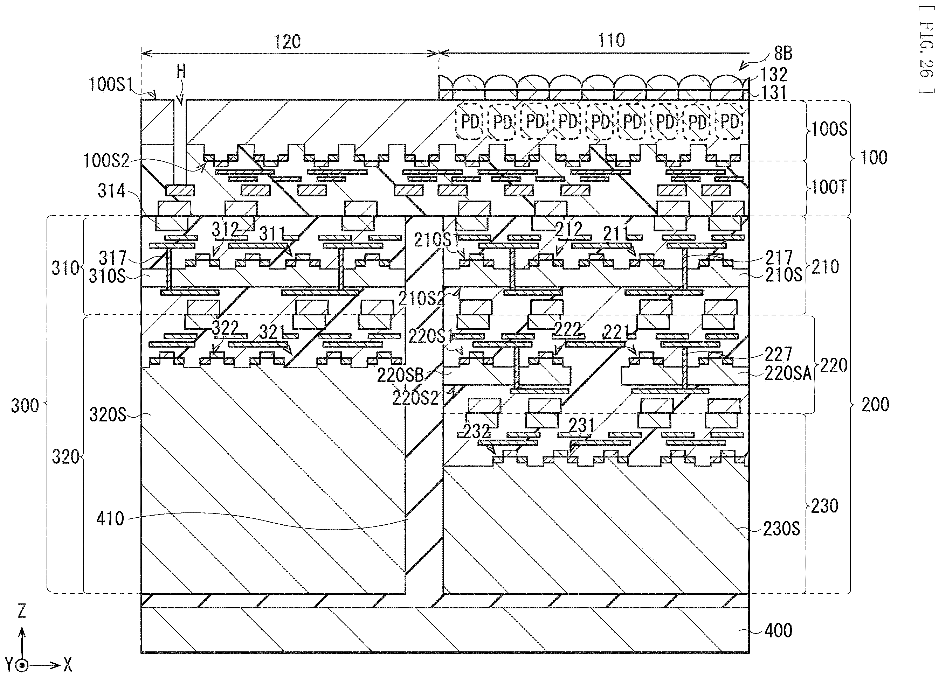

It is to be noted that it is possible to combine this technique with any one of the above-described embodiment and Modification Examples 1 to 5. For example, it is possible to apply this technique also to a configuration in which, as in an imaging device 8A illustrated in FIG. 25, the semiconductor layer 100S-1 in which the photodiode PD is formed to be embedded in each of the plurality of sensor pixels P and the semiconductor layer 100S-2 including the readout circuit that outputs the pixel signals on the basis of electric charge output from the sensor pixels P are stacked. Further, for example, it is possible to apply this technique also to a configuration in which, as in an imaging device 8B illustrated in FIG. 26, three semiconductor layers are stacked in the first CoW layer 200 and two semiconductor layers are stacked in the second CoW layer 300.

As described above, in the imaging devices 8, 8A, and 8B of this modification example, the second layer 220 configuring the first CoW layer 200 includes two semiconductor layers 220A and 220B that are smaller than the semiconductor layer 210S of the first layer 210 and the semiconductor layer 230S of the third layer 230. This makes it possible to remove restrictions on chips to be mounted on the sensor substrate 100. That is, for example, it is possible to use a general-purpose chip such as a DRAM, and hence, as compared with the above-described embodiment, it is possible for the imaging devices 8, 8A, and 8B in this modification example to achieve higher functionality and more reduction in cost.

### (2-7. Modification Example 7)

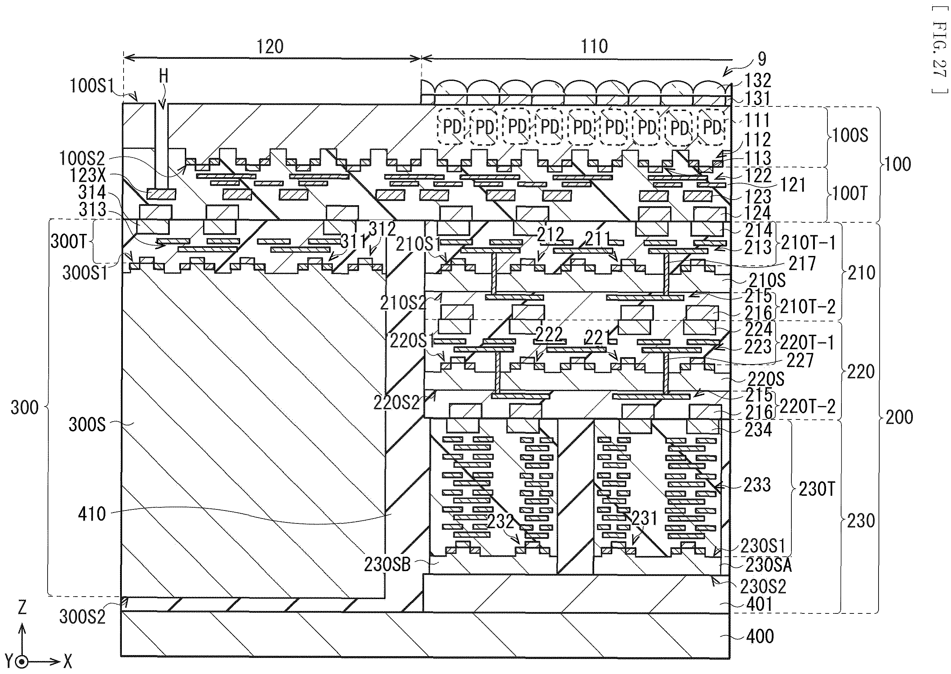

FIG. 27 is a diagram schematically illustrating an example of a cross-sectional configuration of an imaging device (an imaging device 9) according to Modification Example 6 of the present disclosure.

In Modification Example 6 above, description has been given of an example in which the second layer 220 configuring the first CoW layer 200 includes two semiconductor layers 220A and 220B smaller than the semiconductor layer 210S of the first layer 210 and the semiconductor layer 230S of the third layer 230, but the present disclosure is not limited thereto. In the imaging device 8 of this modification example, the first CoW layer 200 includes the third layer 230 mounted on the support substrate 400 side. In the third layer 230, a plurality of semiconductor layers (in this case, two semiconductor layers 230SA and 230SB) smaller than the semiconductor layer 210S of the first layer 210 and the semiconductor layer 220S of the second layer 220 is disposed side by side on a support substrate 401. Except for this point, the imaging device 8 has a configuration substantially similar to that of the imaging device 1 of the above-described embodiment.

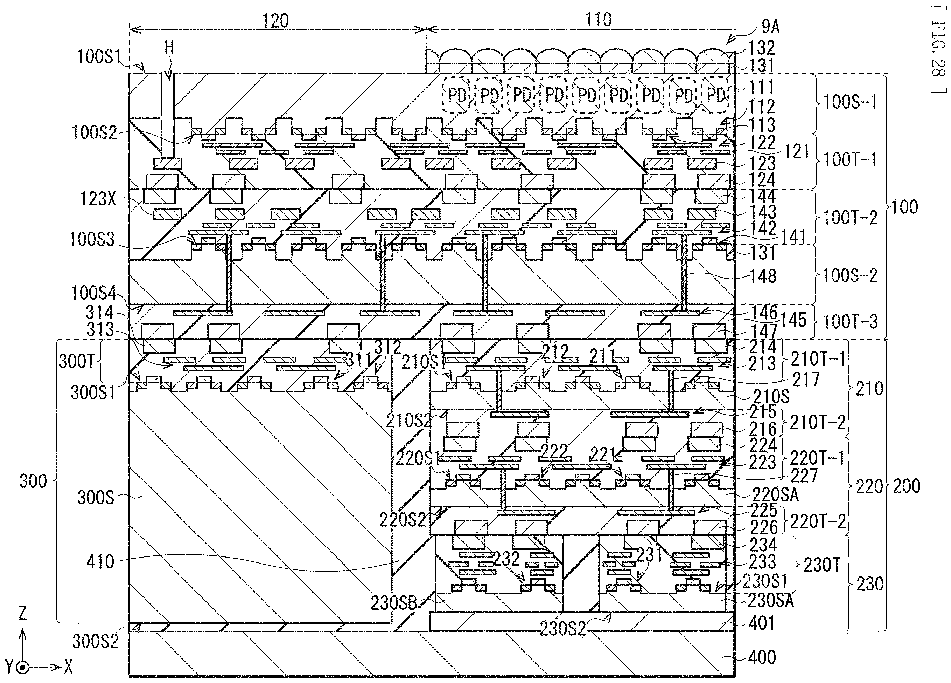

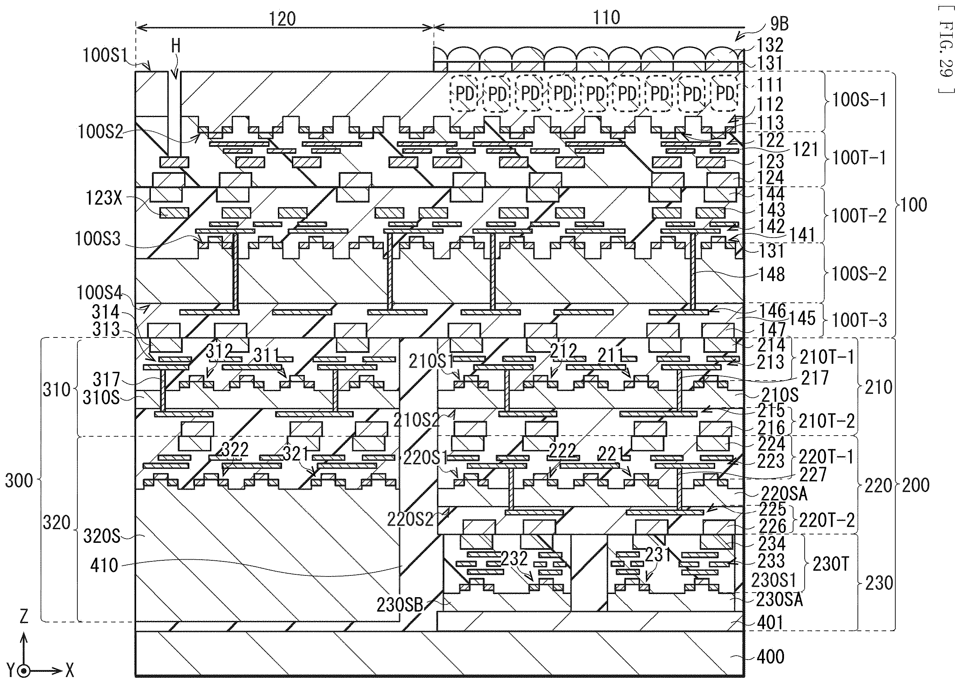

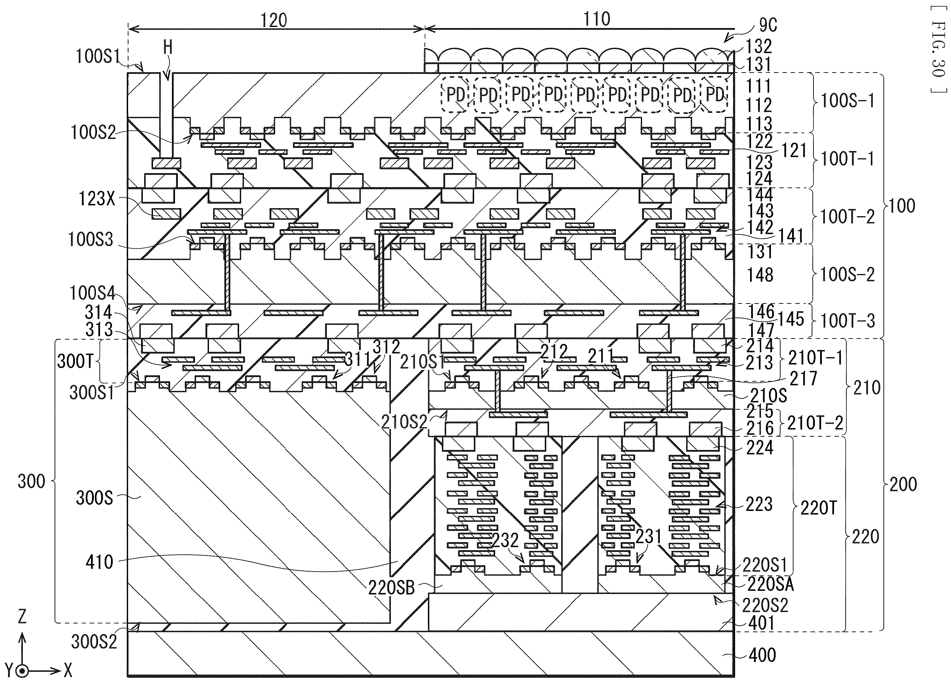

It is to be noted that it is possible to combine this technique with any one of the above-described embodiment and Modification Examples 1 to 6. For example, it is possible to apply this technique also to a configuration in which, as in an imaging device 9A illustrated in FIG. 28, the semiconductor layer 100S-1 in which the photodiode PD is formed to be embedded in each of the plurality of sensor pixels P and the semiconductor layer 100S-2 including the readout circuit that outputs the pixel signals on the basis of electric charge output from the sensor pixels P are stacked. Further, for example, it is possible to apply this technique also to the third layer 230 of the first CoW layer 200 in a configuration in which, as in an imaging device 8B illustrated in FIG. 29, three semiconductor layers are stacked in the first CoW layer 200 and two semiconductor layers are stacked in the second CoW layer 300. Moreover, for example, it is possible to apply this technique also to the second layer 220 of the first CoW layer 200 in a configuration in which, as in an imaging device 9C illustrated in FIG. 30, two semiconductor layers are stacked in the first CoW layer 200 and one semiconductor layer is stacked in the second CoW layer 300.

As described above, in the imaging devices 9, 9A, 9B, and 9C of this modification example, the semiconductor layer (for example, the semiconductor layer 230S of the third layer 230) mounted closest to the support substrate 400 side in the first CoW layer 200 is formed as a semiconductor layer that is smaller than the semiconductor layers of other layers (for example, the semiconductor layer 210S of the first layer 210 and the semiconductor layer 220S of the second layer 220), and a plurality of the semiconductor layers (in this case, the two semiconductor layers 230SA and 230SB) is stacked side by side on the support substrate 401. This makes it possible to remove restriction of chips to be mounted on the sensor substrate 100. That is, for example, it is possible to use a general-purpose chip such as a DRAM, and hence, as compared with the above-described embodiment, it is possible for the imaging devices 9, 9A, 9B, and 9C in this modification example to achieve higher functionality and more reduction in cost.

### <3. Application Example>

FIG. 15 is a diagram illustrating an example of a schematic configuration of an imaging system 10 including the imaging device (for example, the imaging device 1) according to any one of the above-described embodiment and Modification Examples 1 to 4.

The imaging system 10 is, for example, an electronic apparatus such as a camera such as a digital still camera or a video camera, or a mobile terminal device such as a smartphone or a tablet terminal. The imaging system 10 includes, for example, the imaging device 1, an optical system 741, a shutter device 742, a DSP circuit 743, a frame memory 744, a display unit 745, a storage unit 746, an operation unit 747, and a power supply unit 748. In the imaging system 10, the imaging device 1, the DSP circuit 743, the frame memory 744, the display unit 745, the storage unit 746, the operation unit 747, and the power supply unit 748 are mutually coupled to each other via a bus line 749.

The imaging device 1 outputs image data corresponding to entering light. The optical system 741 includes one or a plurality of lenses, and guides light (entering light) from a subject to the imaging device 1 to form an image on a light receiving surface of the imaging device 1. The shutter device 742 is disposed between the optical system 741 and the imaging device 1 to control a light irradiating period to the imaging device 1 and a light blocking period in accordance with control of a drive circuit. The DSP circuit 743 is a signal processing circuit that processes a signal (image data) output from the imaging device 1. The frame memory 744 temporarily holds, in units of frames, image data processed by the DSP circuit 743. The display unit 745 includes, for example, a panel-type display device such as a liquid crystal panel or an organic EL (Electro Luminescence) panel, and displays a moving image or still image imaged by the imaging device 1. The storage unit 746 records the image data of the moving image or still image imaged by the imaging device 1 in a recording medium such as a semiconductor memory or a hard disk. The operation unit 747 outputs an operation command for various functions included in the imaging system 10 in accordance with an operation performed by the user. The power supply unit 748 supplies various types of electric power serving as operation power of the imaging device 1, the DSP circuit 743, the frame memory 744, the display unit 745, the storage unit 746, and the operation unit 747 to those supply targets as appropriate.

Next, an imaging procedure in the imaging system 10 is described.

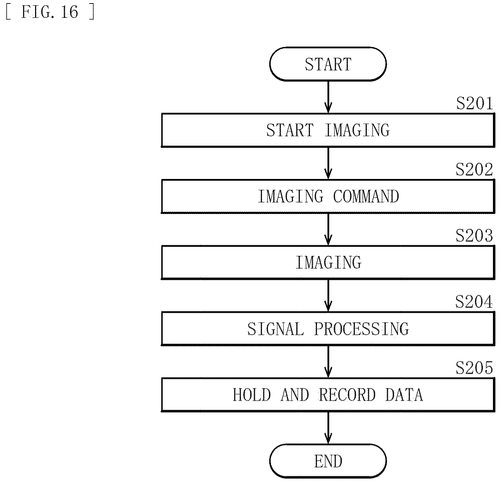

FIG. 16 is a diagram illustrating an example of a flowchart of an imaging operation in the imaging system 10. The user operates the operation unit 747 to give an instruction to start imaging (Step S201). In response thereto, the operation unit 747 transmits an imaging command to the imaging device 1 (Step S202). When the imaging device 1 (specifically, a system control circuit) receives the imaging command, imaging in a predetermined imaging method is executed (Step S203).

The imaging device 1 outputs the image data obtained through imaging to the DSP circuit 743. In this case, the image data refers to data for all pixels of pixel signals generated on the basis of electric charge temporarily held in the floating diffusions FD. The DSP circuit 743 performs predetermined signal processing (for example, noise reduction processing) on the basis of the image data input from the imaging device 1 (Step S204). The DSP circuit 743 causes the frame memory 744 to hold the image data subjected to the predetermined signal processing, and the frame memory 744 causes the storage unit 746 to store the image data (Step S205). As described above, the imaging in the imaging system 10 is performed.

In this application example, the imaging device (for example, the imaging device 1) according to any one of the above-described embodiment and Modification Examples 1 to 4 thereof is applied to the imaging system 10. This makes it possible to downsize the imaging device 1 or increase the definition of the imaging device 1, and hence it is possible to provide a small-sized or high-definition imaging system 10.

### <4. Example of Practical Application>

### (Example of Practical Application to Mobile Body)

The technique according to the present disclosure (present technology) is applicable to a variety of products. For example, the technique according to the present disclosure may be achieved as a device mounted on any type of mobile body such as a vehicle, an electric vehicle, a hybrid electric vehicle, a motorcycle, a bicycle, a personal mobility, an airplane, a drone, a vessel, a robot, and the like.

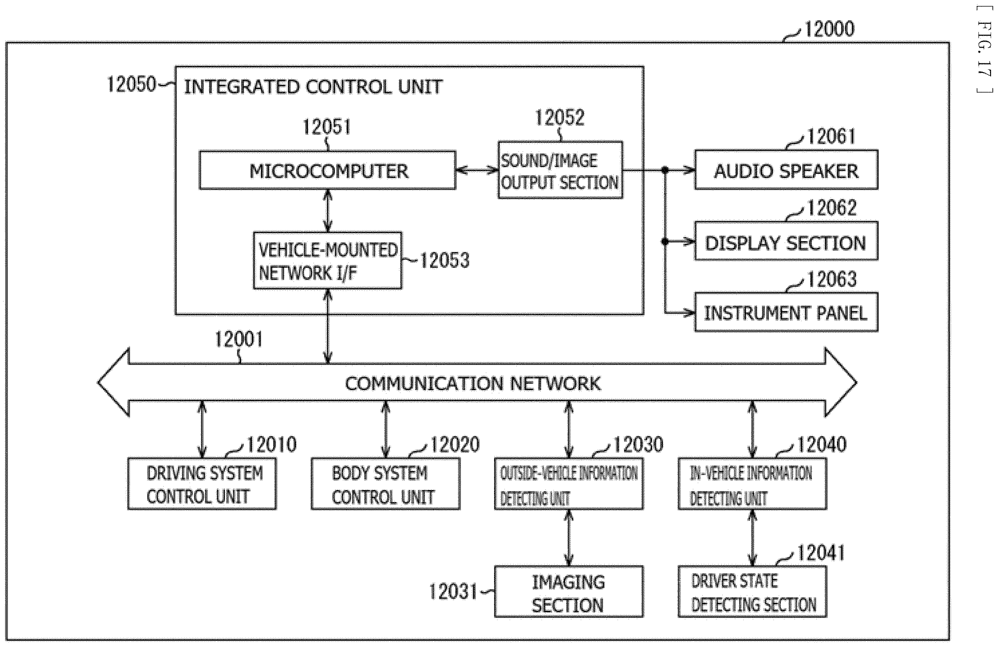

FIG. 17 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 17, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 17, an audio speaker 12061, a display section 12062, and an instrument panel 12063 are illustrated as the output device. The display section 12062 may, for example, include at least one of an on-board display and a head-up display.

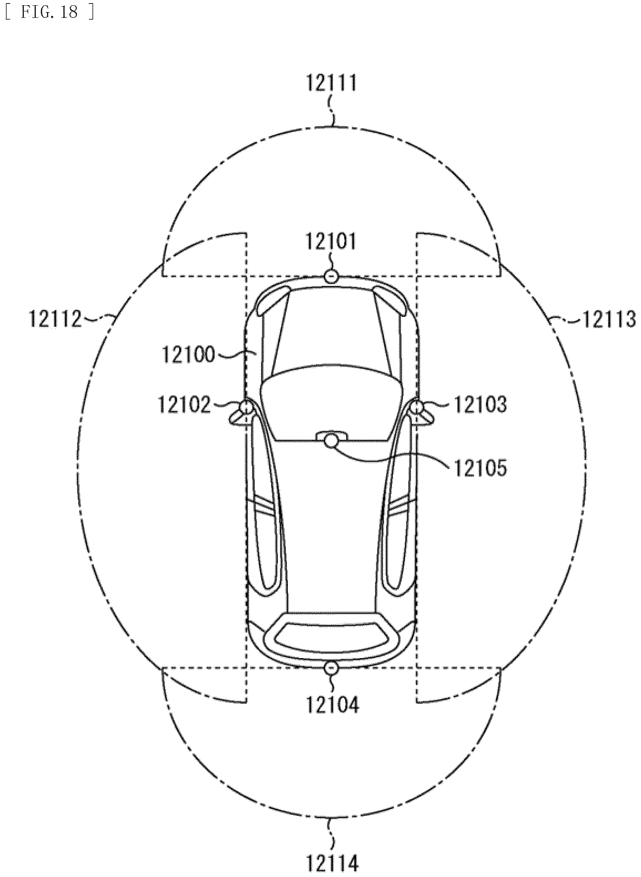

FIG. 18 is a diagram depicting an example of the installation position of the imaging section 12031.

In FIG. 18, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 18 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

In the forgoing, described is one example of the mobile body control system to which the technique according to the present disclosure is applicable. The technique according to the present disclosure is applicable to the imaging section 12031 among the above-described components. Specifically, the solid-state imaging device 1 according to the foregoing embodiment and the modification examples thereof is applicable to the imaging section 12031. The application of the technique according to the present disclosure to the imaging section 12031 makes it possible to obtain a high-definition captured image with less noise. It is thus possible to perform a highly accurate control with use of the captured image in the mobile body control system.

### (Example of Practical Application to Endoscopic Surgery System)

The technique according to the present disclosure (the present technology) is applicable to various products. For example, the technique according to the present disclosure may be applied to an endoscopic surgery system.

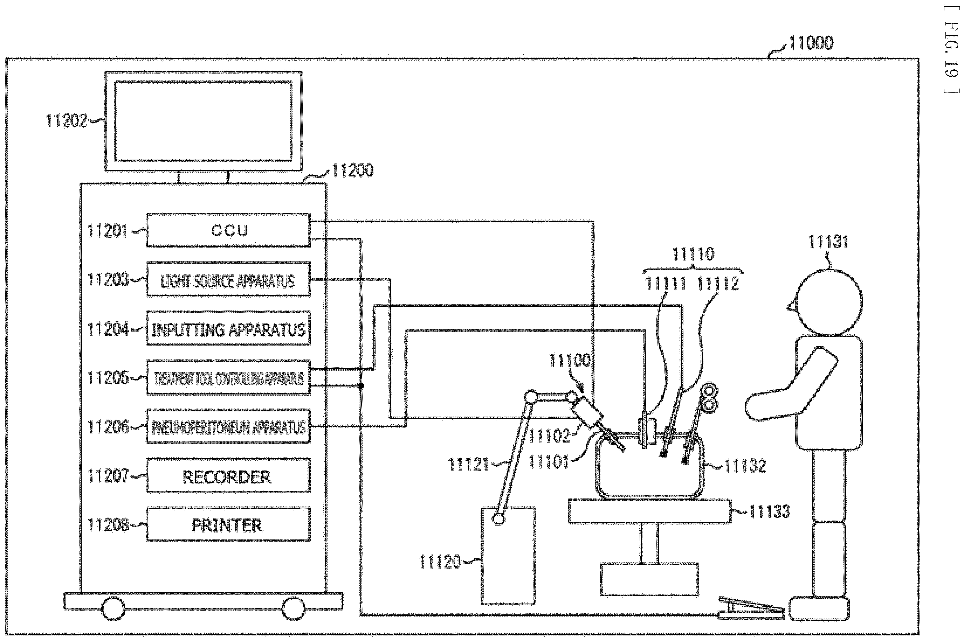

FIG. 19 is a view depicting an example of a schematic configuration of an endoscopic surgery system to which the technology according to an embodiment of the present disclosure (present technology) can be applied.

In FIG. 19, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrow-band light and/or excitation light suitable for special light observation as described above.

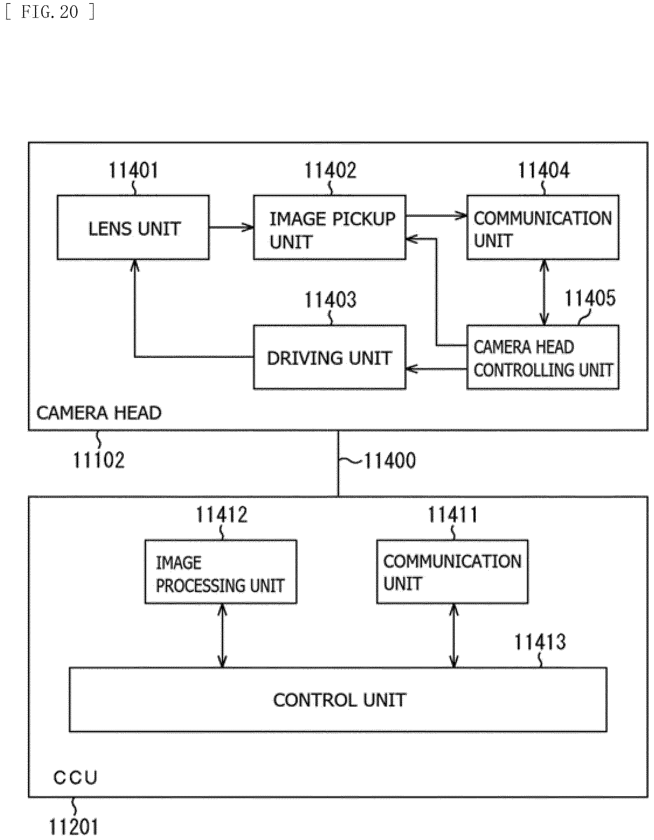

FIG. 20 is a block diagram depicting an example of a functional configuration of the camera head 11102 and the CCU 11201 depicted in FIG. 19.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

In the forgoing, described is one example of the endoscopic surgery system to which the technique according to the present disclosure is applicable. The technique according to the present disclosure is applicable to the imaging unit 11402 provided on the camera head 11102 of the endoscope 11100 among the above-described components. The application of the technique according to the present disclosure to the imaging unit 11402 makes it possible to reduce the size of or increase the definition of the imaging unit 11402. It is thus possible to provide the endoscope 11100 that is reduced in size or increased in definition.

The present disclosure has been described above by means of the embodiment, Modification Examples 1 to 7, the application example, and the usage examples, but the present disclosure is not limited to the above-described embodiment and others, and various modifications may be made thereto.

It is to be noted that the effects described herein are merely examples. The effects of the present disclosure are not limited to the effects described herein, The present disclosure may have effects other than the effects described herein.

It is to be noted that the present disclosure may take the following configurations. With the present technique having the following configurations, it is possible to mount a desired circuit chip at a desired position, and this makes it possible to achieve both of high functionality and reduction in cost.
(1) A semiconductor device including:
   a first substrate having a first surface and a second surface that are opposed to each other, the first substrate including a plurality of semiconductor elements formed on a side of the first surface;
   a second substrate mounted on the second surface of the first substrate, the second substrate including a plurality of semiconductor layers being stacked, the plurality of semiconductor layers each including one or a plurality of circuits; and
   a third substrate mounted side by side to the second substrate on the second surface of the first substrate, the third substrate including one or a plurality of semiconductor layers being stacked, the one or the plurality of semiconductor layers each including one or a plurality of circuits.
(2) The semiconductor device according to (1) described above, in which each of the second substrate and the third substrate includes the plurality of semiconductor layers being stacked.
(3) The semiconductor device according to any one of (1) or (2) described above, in which the second substrate and the third substrate are different from each other in number of the semiconductor layers.
(4) The semiconductor device according to any one of (1) to (3) described above, in which the first substrate and the second substrate are electrically coupled to each other by hybrid bonding, and the first substrate and the third substrate are electrically coupled to each other by hybrid bonding.
(5) The semiconductor device according to any one of (1) to (4) described above, in which
   the first substrate and the second substrate are electrically coupled to each other by CuCu bonding, and the first substrate and the third substrate are electrically coupled to each other by CuCu bonding,
   an insulating film is embedded between the second substrate and the third substrate, and
   a common support substrate shared by the second substrate and the third substrate is provided on surfaces of the second substrate and the third substrate on a side opposite to surfaces bonded to the first substrate.
(6) The semiconductor device according to any one of (1) to (5) described above, in which the second substrate and the third substrate include, as the plurality of semiconductor layers, a dummy semiconductor layer not including the one or the plurality of circuits.
(7) The semiconductor device according to (6) described above, in which the dummy semiconductor layer is bonded to another one of the semiconductor layers by an insulating film.
(8) The semiconductor device according to (6) described above, in which the dummy semiconductor layer is bonded to another one of the semiconductor layers by hybrid bonding.
(9) The semiconductor device according to any one of (1) to (8) described above, in which the second substrate and the third substrate include, as the plurality of semiconductor layers, semiconductor layers having sizes different from each other.
(10) The semiconductor device according to any one of (1) to (9) described above, in which at least a portion of the one or the plurality of semiconductor layers configuring the second substrate and the third substrate includes a plurality of semiconductor layers disposed side by side in an in-plane direction.
(11) The semiconductor device according to any one of (1) to (10) described above, in which
   the plurality of semiconductor elements includes a plurality of light receiving elements,
   the first substrate includes a pixel array section and a peripheral section, the pixel array section including a plurality of pixels disposed in an array shape, the plurality of pixels including the plurality of respective light receiving elements, the peripheral section being provided around the pixel array section,
   the second substrate is mounted at a position corresponding to the pixel array section, and
   the third substrate is mounted at a position corresponding to the peripheral section.
(12) The semiconductor device according to (11) described above, in which
   the first substrate includes a semiconductor layer having the plurality of light receiving elements provided therein, and
   the semiconductor layer includes a plurality of pixel transistors on a surface of the semiconductor layer on a side opposite to a light entering surface.
(13) The semiconductor device according to (11) or (12) described above, in which the first substrate includes a first semiconductor layer having the plurality of light receiving elements provided therein, and a second semiconductor layer including a plurality of pixel transistors, the second semiconductor layer being provided on a side opposite to a light entering surface of the first semiconductor layer.
(14) The semiconductor device according to any one of (11) to (13) described above, in which the plurality of circuits provided in the plurality of semiconductor layers configuring the second substrate is electrically coupled for each of the pixels.
(15) The semiconductor device according to (14) described above, in which
   the second substrate includes, as the plurality of semiconductor layers, a third semiconductor layer including a plurality of analog circuits, and a fourth semiconductor layer including a plurality of logic circuits, and
   the third semiconductor layer and the fourth semiconductor layer are stacked in this order from a side of the first substrate.
(16) The semiconductor device according to (15) described above, in which
   the third semiconductor layer includes, as the plurality of analog circuits, a comparator, a negative MOS, and an analog-to-digital converter circuit,
   the fourth semiconductor layer includes, as the plurality of logic circuits, a latch circuit, a sensor interface circuit, and a digital unit circuit, and
   the plurality of analog circuits is coupled to the plurality of logic circuits.
(17) The semiconductor device according to (15) or (16) described above, in which the second substrate further includes, as the plurality of semiconductor layers, a fifth semiconductor layer including a memory element.
(18) The semiconductor device according to any one of (15) to (17) described above, in which the second substrate further includes, as the plurality of semiconductor layers, a sixth semiconductor layer including an interface circuit.
(19) The semiconductor device according to any one of (11) to (18) described above, in which
   the plurality of pixels is divided into a plurality of pixel blocks, and
   the plurality of circuits provided in the plurality of semiconductor layers configuring the second substrate is electrically coupled to the plurality of respective pixel blocks.
(20) The semiconductor device according to (19) described above, in which
   the second substrate includes, as the plurality of semiconductor layers, a third semiconductor layer including a plurality of analog circuit sections, and a fourth semiconductor layer including a plurality of logic circuit sections, and
   the third semiconductor layer and the fourth semiconductor layer are stacked in this order from a side of the first substrate.
(21) The semiconductor device according to (20) described above, in which
   the third semiconductor layer includes, as the plurality of analog circuit sections, a plurality of analog-to-digital converter blocks,
   each of the plurality of pixel blocks and corresponding one of the plurality of analog-to-digital converter blocks are coupled to each other via a vertical signal line, and
   each of the plurality of analog-to-digital converter blocks is coupled to corresponding one of the plurality of logic circuit sections.
(22) The semiconductor device according to (21) described above, in which the second substrate further includes, as the plurality of semiconductor layers, a fifth semiconductor layer including a memory element.
(23) The semiconductor device according to (21) or (22) described above, in which the third substrate further includes, as the plurality of semiconductor layers, a sixth semiconductor layer including an interface circuit.
(24) The semiconductor device according to any one of (1) to (23) described above, in which the plurality of semiconductor layers of each of the second substrate and the third substrate includes semiconductor materials that are different from each other.
(25) The semiconductor device according to any one of (1) to (24) described above, in which the plurality of semiconductor layers includes any one of silicon, silicon germanium, or germanium.
(26) The semiconductor device according to any one of (1) to (25) described above, in which the plurality of semiconductor layers includes a one-dimensional material or a two-dimensional material.
(27) The semiconductor device according to (26) described above, in which the one-dimensional material includes a carbon nanotube.
(28) The semiconductor device according to (26) described above, in which the two-dimensional material includes transition metal dichalcogenide or graphene.
(29) The semiconductor device according to any one of (1) to (28) described above, in which the plurality of semiconductor layers includes a compound semiconductor.
(30) The semiconductor device according to any one of (1) to (29) described above, in which
   the plurality of semiconductor layers includes a semiconductor layer including an n-MOS transistor and a semiconductor layer including a p-MOS transistor,
   the semiconductor layer including the n-MOS transistor includes silicon, and
   the semiconductor layer including the p-MOS transistor includes silicon germanium or germanium.
(31) The semiconductor device according to any one of (1) to (30) described above, in which
   the plurality of semiconductor layers includes a semiconductor layer including an n-MOS transistor and a semiconductor layer including a p-MOS transistor,
   the semiconductor layer including the n-MOS transistor includes a compound semiconductor, and
   the semiconductor layer including the p-MOS transistor includes silicon.
(32) The semiconductor device according to any one of (1) to (31) described above, in which the semiconductor device includes, as the plurality of semiconductor layers, a semiconductor layer including an analog front-end circuit section and including a compound semiconductor, and a semiconductor layer including a high-frequency circuit and including silicon.
(33) The semiconductor device according to any one of (1) to (32) described above, in which a portion of the plurality of semiconductor layers forms a baseband circuit.
(34) The semiconductor device according to any one of (1) to (33) described above, further including:
   a substrate having optical transparency provided on the side of the first surface of the first substrate; and
   an electrode for use in coupling to an outside, the electrode being provided on a surface of the third substrate on a side opposite to a surface facing the first substrate,
   in which the first substrate and the electrode are electrically coupled to each other via a through-electrode passing through the third substrate.

The present application claims the benefit of Japanese Priority Patent Application JP2023-042942 filed with the Japan Patent Office on March 17, 2023, the entire contents of which are incorporated herein by reference.

It should be understood by those skilled in the art that various modifications, combinations, sub-combinations and alterations may occur depending on design requirements and other factors insofar as they are within the scope of the appended claims or the equivalents thereof.

## Claims

1. A semiconductor device comprising:
a first substrate having a first surface and a second surface that are opposed to each other, the first substrate including a plurality of semiconductor elements formed on a side of the first surface;
a second substrate mounted on the second surface of the first substrate, the second substrate including a plurality of semiconductor layers being stacked, the plurality of semiconductor layers each including one or a plurality of circuits; and
a third substrate mounted side by side to the second substrate on the second surface of the first substrate, the third substrate including one or a plurality of semiconductor layers being stacked, the one or the plurality of semiconductor layers each including one or a plurality of circuits.

2. The semiconductor device according to claim 1, wherein each of the second substrate and the third substrate includes the plurality of semiconductor layers being stacked.

3. The semiconductor device according to claim 1, wherein the second substrate and the third substrate are different from each other in number of the semiconductor layers.

4. The semiconductor device according to claim 1, wherein the first substrate and the second substrate are electrically coupled to each other by hybrid bonding, and the first substrate and the third substrate are electrically coupled to each other by hybrid bonding.

5. The semiconductor device according to claim 1, wherein
the first substrate and the second substrate are electrically coupled to each other by CuCu bonding, and the first substrate and the third substrate are electrically coupled to each other by CuCu bonding,
an insulating film is embedded between the second substrate and the third substrate, and
a common support substrate shared by the second substrate and the third substrate is provided on surfaces of the second substrate and the third substrate on a side opposite to surfaces bonded to the first substrate.

6. The semiconductor device according to claim 1, wherein the second substrate and the third substrate include, as the plurality of semiconductor layers, a dummy semiconductor layer not including the one or the plurality of circuits.

7. The semiconductor device according to claim 6, wherein the dummy semiconductor layer is bonded to another one of the semiconductor layers by an insulating film.

8. The semiconductor device according to claim 6, wherein the dummy semiconductor layer is bonded to another one of the semiconductor layers by hybrid bonding.

9. The semiconductor device according to claim 1, wherein the second substrate and the third substrate include, as the plurality of semiconductor layers, semiconductor layers having sizes different from each other.

10. The semiconductor device according to claim 1, wherein at least a portion of the one or the plurality of semiconductor layers configuring the second substrate and the third substrate includes a plurality of semiconductor layers disposed side by side in an in-plane direction.

11. The semiconductor device according to claim 1, wherein
the plurality of semiconductor elements comprises a plurality of light receiving elements,
the first substrate includes a pixel array section and a peripheral section, the pixel array section including a plurality of pixels disposed in an array shape, the plurality of pixels including the plurality of respective light receiving elements, the peripheral section being provided around the pixel array section,
the second substrate is mounted at a position corresponding to the pixel array section, and
the third substrate is mounted at a position corresponding to the peripheral section.

12. The semiconductor device according to claim 11, wherein
the first substrate includes a semiconductor layer having the plurality of light receiving elements provided therein, and
the semiconductor layer includes a plurality of pixel transistors on a surface of the semiconductor layer on a side opposite to a light entering surface.

13. The semiconductor device according to claim 11, wherein the first substrate includes a first semiconductor layer having the plurality of light receiving elements provided therein, and a second semiconductor layer including a plurality of pixel transistors, the second semiconductor layer being provided on a side opposite to a light entering surface of the first semiconductor layer.

14. The semiconductor device according to claim 11, wherein the plurality of circuits provided in the plurality of semiconductor layers configuring the second substrate is electrically coupled for each of the pixels.

15. The semiconductor device according to claim 14, wherein
the second substrate includes, as the plurality of semiconductor layers, a third semiconductor layer including a plurality of analog circuits, and a fourth semiconductor layer including a plurality of logic circuits, and
the third semiconductor layer and the fourth semiconductor layer are stacked in this order from a side of the first substrate.

16. The semiconductor device according to claim 15, wherein
the third semiconductor layer includes, as the plurality of analog circuits, a comparator, a negative MOS, and an analog-to-digital converter circuit,
the fourth semiconductor layer includes, as the plurality of logic circuits, a latch circuit, a sensor interface circuit, and a digital unit circuit, and
the plurality of analog circuits is coupled to the plurality of logic circuits.

17. The semiconductor device according to claim 15, wherein the second substrate further includes, as the plurality of semiconductor layers, a fifth semiconductor layer including a memory element.

18. The semiconductor device according to claim 15, wherein the second substrate further includes, as the plurality of semiconductor layers, a sixth semiconductor layer including an interface circuit.

19. The semiconductor device according to claim 11, wherein
the plurality of pixels is divided into a plurality of pixel blocks, and
the plurality of circuits provided in the plurality of semiconductor layers configuring the second substrate is electrically coupled to the plurality of respective pixel blocks.

20. The semiconductor device according to claim 19, wherein
the second substrate includes, as the plurality of semiconductor layers, a third semiconductor layer including a plurality of analog circuit sections, and a fourth semiconductor layer including a plurality of logic circuit sections, and
the third semiconductor layer and the fourth semiconductor layer are stacked in this order from a side of the first substrate.

21. The semiconductor device according to claim 20, wherein
the third semiconductor layer includes, as the plurality of analog circuit sections, a plurality of analog-to-digital converter blocks,
each of the plurality of pixel blocks and corresponding one of the plurality of analog-to-digital converter blocks are coupled to each other via a vertical signal line, and
each of the plurality of analog-to-digital converter blocks is coupled to corresponding one of the plurality of logic circuit sections.

22. The semiconductor device according to claim 21, wherein the second substrate further includes, as the plurality of semiconductor layers, a fifth semiconductor layer including a memory element.

23. The semiconductor device according to claim 21, wherein the third substrate further includes, as the plurality of semiconductor layers, a sixth semiconductor layer including an interface circuit.

24. The semiconductor device according to claim 1, wherein the plurality of semiconductor layers of each of the second substrate and the third substrate includes semiconductor materials that are different from each other.

25. The semiconductor device according to claim 1, wherein the plurality of semiconductor layers includes any one of silicon, silicon germanium, or germanium.

26. The semiconductor device according to claim 1, wherein the plurality of semiconductor layers includes a one-dimensional material or a two-dimensional material.

27. The semiconductor device according to claim 26, wherein the one-dimensional material comprises a carbon nanotube.

28. The semiconductor device according to claim 26, wherein the two-dimensional material comprises transition metal dichalcogenide or graphene.

29. The semiconductor device according to claim 1, wherein the plurality of semiconductor layers includes a compound semiconductor.

30. The semiconductor device according to claim 1, wherein
the plurality of semiconductor layers includes a semiconductor layer including an n-MOS transistor and a semiconductor layer including a p-MOS transistor,
the semiconductor layer including the n-MOS transistor includes silicon, and
the semiconductor layer including the p-MOS transistor includes silicon germanium or germanium.

31. The semiconductor device according to claim 1, wherein
the plurality of semiconductor layers includes a semiconductor layer including an n-MOS transistor and a semiconductor layer including a p-MOS transistor,
the semiconductor layer including the n-MOS transistor includes a compound semiconductor, and
the semiconductor layer including the p-MOS transistor includes silicon.

32. The semiconductor device according to claim 1, wherein the semiconductor device includes, as the plurality of semiconductor layers, a semiconductor layer including an analog front-end circuit section and including a compound semiconductor, and a semiconductor layer including a high-frequency circuit and including silicon.

33. The semiconductor device according to claim 1, wherein a portion of the plurality of semiconductor layers forms a baseband circuit.

34. The semiconductor device according to claim 1, further comprising:
a substrate having optical transparency provided on the side of the first surface of the first substrate; and
an electrode for use in coupling to an outside, the electrode being provided on a surface of the third substrate on a side opposite to a surface facing the first substrate,
wherein the first substrate and the electrode are electrically coupled to each other via a through-electrode passing through the third substrate.
